# EUROPEAN PATENT SPECIFICATION

(11) **EP 4 529 367 B1**
(45) Date of publication and mention of the grant of the patent: **28.10.2026**
(21) Application number: 24746171.8
(22) Date of filing: 30.07.2024
(51) Int. Cl.: H05K 1/14, H04M 1/02, G06F 1/184, H05K 1/02, G06F 1/16

(54) **ELECTRONIC DEVICE COMPRISING FLEXIBLE CIRCUIT BOARD**
ELEKTRONISCHE VORRICHTUNG MIT FLEXIBLER LEITERPLATTE
DISPOSITIF ÉLECTRONIQUE COMPRENANT UNE CARTE DE CIRCUIT IMPRIMÉ FLEXIBLE

(30) Priority: 08.08.2023 KR 20230103376; 05.09.2023 KR 20230117539
(43) Date of publication of application: 26.03.2025
(73) Proprietor: Samsung Electronics Co., Ltd., Suwon-si, Gyeonggi-do 16677 (KR)
(72) Inventor: KANG, Jooyoung, Suwon-si, Gyeonggi-do 16677 (KR); KIM, Youngchul, Suwon-si, Gyeonggi-do 16677 (KR); KIM, Hyunsuk, Suwon-si, Gyeonggi-do 16677 (KR); SEO, Soohyun, Suwon-si, Gyeonggi-do 16677 (KR); YUN, Inkuk, Suwon-si, Gyeonggi-do 16677 (KR); LEE, Soyoung, Suwon-si, Gyeonggi-do 16677 (KR); JANG, Seokmin, Suwon-si, Gyeonggi-do 16677 (KR)
(74) Representative: Gulde & Partner
(86) International application number: PCT/KR2024/011123
(87) International publication number: WO 2025/033815

(56) References cited:
- KR-A- 20190 101 826
- KR-A- 20220 064 117
- KR-A- 20220 072 540
- KR-A- 20230 063 179
- US-A1- 2008 047 135

## Description

### [Technical Field]

Various embodiments disclosed herein relate to an electronic device. For example, various embodiments relate to an electronic device including a flexible circuit board.

### [Background Art]

Due to the development of the information and communication technology and semiconductor technology, various functions are being integrated into a single portable electronic device. For example, an electronic device may implement various functions, such as an entertainment function (e.g., a game function), a multimedia function (e.g., a music/video replay function), a communication and security function for mobile banking, a schedule management function, and an e-wallet function, in addition to a communication function. These electronic devices are being downsized to be conveniently carried by users.

As mobile communication service is extended to the multimedia service area, it is necessary to increase the size of a display of an electronic device in order to allow users to fully utilize the multimedia service as well as a voice call or short message service. However, the size of the display of the electronic device is in a trade-off relationship with the downsizing of the electronic device. In similar regards, publication KR20230063179 relates to a foldable electronic device in which first and second housings each accommodate respective printed circuit boards and are coupled for rotation about a folding axis by at least one hinge structure.

The above information is provided as related art to assist in understanding the disclosure. No assertion or determination has been made as to whether any of the above might be applicable as prior art with regard to the disclosure.

### [Detailed Description of the Invention]

### [Technical Solution]

An electronic device is provided corresponding to the appended claims..

The electronic device according to an embodiment of the disclosure may include a second housing to which the first housing is coupled to be movable.

The electronic device according to an embodiment of the disclosure may include a first circuit board disposed inside the first housing to be movable relative to the second housing.

The electronic device according to an embodiment of the disclosure may include a second circuit board disposed inside the second housing.

The electronic device according to an embodiment of the disclosure may include a first flexible circuit board electrically connecting the first circuit board and the second circuit board, at least a portion of the first flexible circuit board being configured to be deformable in response to a movement of the first circuit board, and the first flexible circuit board including a first flexible portion and a first rigid portion formed between the first circuit board and the first flexible portion.

The electronic device according to an embodiment of the disclosure may include a second flexible circuit board electrically connecting the first circuit board and the second circuit board, at least a portion of the second flexible circuit board being coupled to the first flexible circuit board and configured to be deformed in response to the deformation of at least a portion of the first flexible circuit board, and the second flexible circuit board including a second flexible portion and a second rigid portion formed between the first circuit board and the second flexible portion.

According to an embodiment of the disclosure, a first boundary portion between the first flexible portion and the first rigid portion of the first flexible circuit board may be dislocated from a second boundary portion formed between the second flexible portion and the second rigid portion of the second flexible circuit board.

An electronic device according to an embodiment of the disclosure may include a first housing.

The electronic device according to an embodiment of the disclosure may include a second housing to which the first housing is coupled to be movable.

The electronic device according to an embodiment of the disclosure may include a first circuit board disposed inside the first housing to be movable relative to the second housing.

The electronic device according to an embodiment of the disclosure may include a second circuit board disposed inside the second housing.

An electronic device according to an embodiment of the disclosure may include a flexible circuit board electrically connecting the first circuit board and the second circuit board.

The flexible circuit board according to an embodiment of the disclosure may include a first flexible portion which is at least partially deformable.

The flexible circuit board according to an embodiment of the disclosure may include a first rigid portion connecting the first flexible portion to the first circuit board.

The flexible printed circuit board according to an embodiment of the disclosure may include a second flexible portion which is at least partially deformable and is spaced apart from the first flexible portion.

The flexible circuit board according to an embodiment of the disclosure may include a second rigid portion connecting the second flexible portion to the second circuit board.

The electronic device according to an embodiment of the disclosure may include a flexible circuit board including a first layer and a second layer, wherein the flexible circuit board electrically connects the first circuit board and the second circuit board via at least one of the first layer and the second layer, and at least a portion of the flexible circuit board is deformable in response to the movement of at least one of the first circuit board and the second circuit board.

According to an embodiment of the disclosure, the first layer may include a (1-1)^{th} flexible portion, which is at least partially deformable, a (1-1)^{th} rigid portion connecting the (1-1)^{th} flexible portion to the first circuit board, and a (1-1)^{th} boundary portion formed between the (1-1)^{th} flexible portion and the (1-1)^{th} rigid portion.

According to an embodiment of the disclosure, the second layer may include a (1-2)^{th} flexible portion, which is at least partially deformable, a (1-2)^{th} rigid portion connecting the (1-2)^{th} flexible portion to the first circuit board, and a (1-2)^{th} boundary portion formed between the (1-2)^{th} flexible portion and the (1-1)^{th} rigid portion.

According to an embodiment, the (1-1)^{th} boundary portion and the (1-2)^{th} boundary portion may be dislocated from each other.

### [Brief Description of Drawings]

FIG. 1 is a block diagram of an electronic device according to various embodiments of the disclosure in a network environment.
FIG. 2 is a view illustrating the state in which a portion of a display according to an embodiment of the disclosure is accommodated in a housing.
FIG. 3 is a view illustrating the state in which a portion of a display according to an embodiment of the disclosure is exposed to the outside of the housing.
FIG. 4 is an exploded view of an electronic device according to an embodiment of the disclosure.
FIG. 5A is a cross-sectional view of an embodiment of the disclosure, taken along reference line A-A' in FIG. 2.
FIG. 5B is a cross-sectional view of an embodiment of the disclosure, taken along reference line B-B' in FIG. 3.
FIG. 6 is a view illustrating a portion of an electronic device according to an embodiment of the disclosure.
FIG. 7A is a view illustrating a portion of an electronic device according to an embodiment of the disclosure.
FIG. 7B is a view illustrating a portion of an electronic device according to an embodiment of the disclosure.
FIG. 7C is a view illustrating a portion of an electronic device according to an embodiment of the disclosure.
FIG. 8A is a view illustrating a portion of an electronic device according to an embodiment of the disclosure.
FIG. 8B is a view illustrating a portion of an electronic device according to an embodiment of the disclosure.
FIG. 9 is a view illustrating a portion of an electronic device according to an embodiment of the disclosure.
FIG. 10A is a view illustrating a portion of an electronic device according to an embodiment of the disclosure.
FIG. 10B is a view illustrating a portion of an electronic device according to an embodiment of the disclosure.
FIG. 11A is a view illustrating a portion of an electronic device according to an embodiment of the disclosure.
FIG. 11B is a view illustrating a portion of an electronic device according to an embodiment of the disclosure.
FIG. 12A is a view illustrating a portion of an electronic device according to an embodiment of the disclosure.
FIG. 12B is a view illustrating a portion of an electronic device according to an embodiment of the disclosure.
FIG. 12C is a view illustrating a portion of an electronic device according to an embodiment of the disclosure.
FIG. 13 is a view illustrating a portion of an electronic device according to an embodiment of the disclosure.
FIG. 14A is a view illustrating a portion of an electronic device according to an embodiment of the disclosure.
FIG. 14B is a view illustrating a portion of an electronic device according to an embodiment of the disclosure.
FIG. 14C is a view illustrating a portion of an electronic device according to an embodiment of the disclosure.

### [Mode for Carrying out the Invention]

The following description made with reference to the accompanying drawings may be provided in order to help a comprehensive understanding of various implementations of the disclosure defined by the claims. A specific embodiment set forth in the following description includes various particular details to help the understanding, but is considered one of various embodiments. Therefore, it will be apparent to those skilled in the art that various changes and modifications may be made to various implementations described herein without departing from the scope and technical idea of the disclosure. In addition, descriptions of well-known functions and configurations may be omitted for clarity and brevity.

The terms and words used in the following description and claims are not limited to bibliographical meanings, but may be used to clearly and consistently describe the various embodiments set forth herein..

It should be appreciated that a singular form such as "a," "an," or "the" also includes the meaning as a plural form, unless the context clearly indicates otherwise. Therefore, for example, "a component surface" may be understood as one or more of the surfaces of a component.

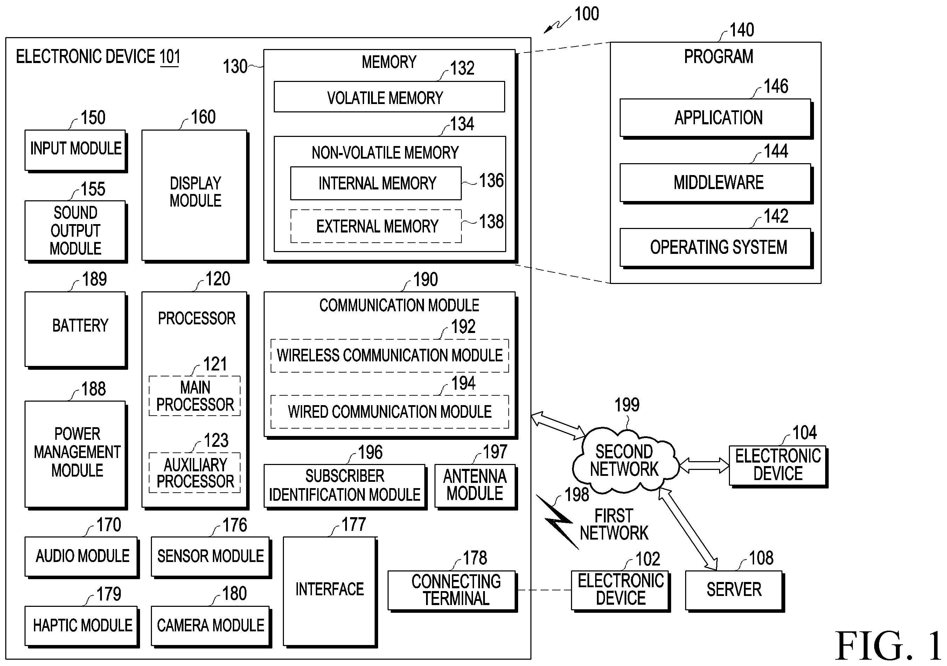

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, , within the scope of the appended claims, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

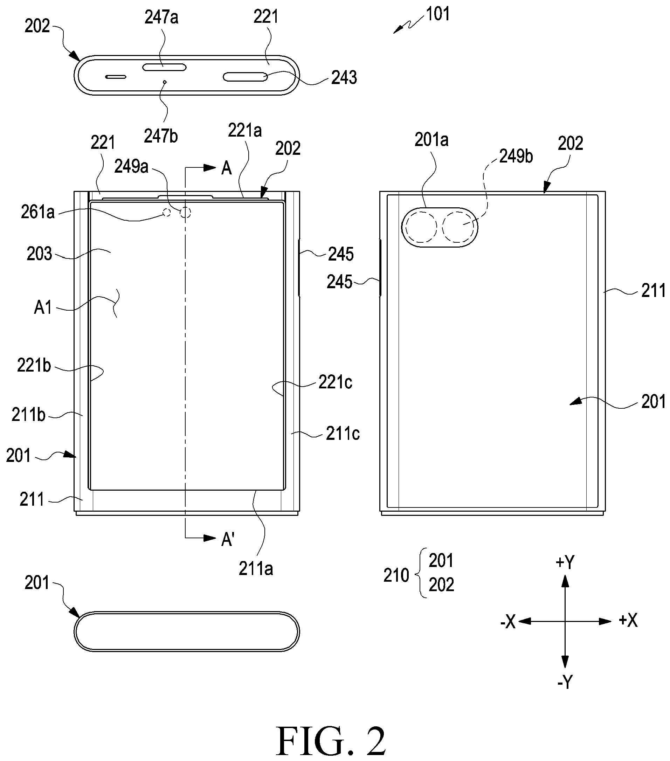

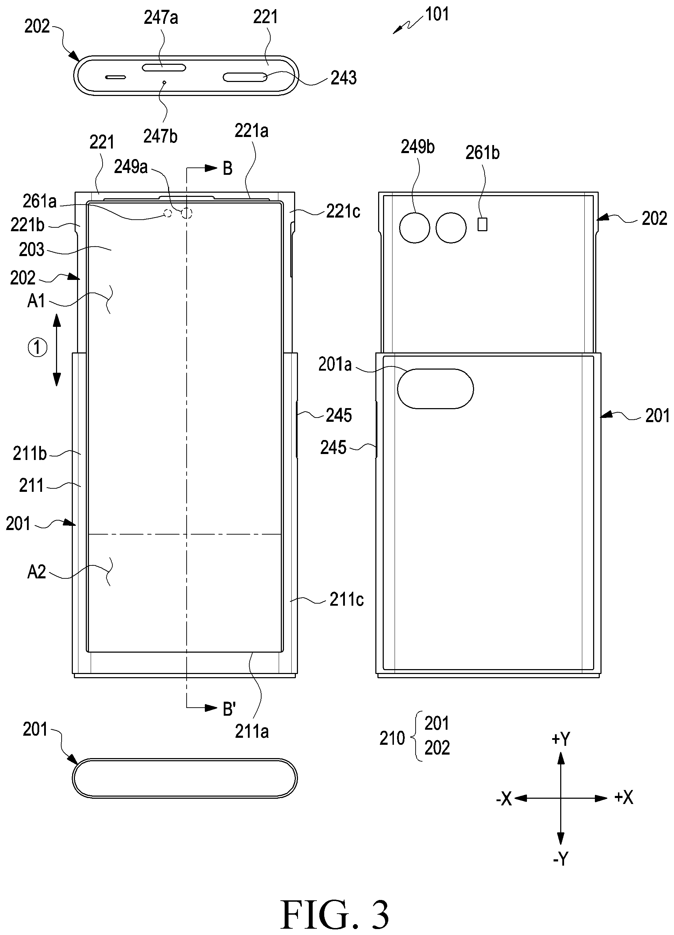

FIG. 2 is a view illustrating the state in which a portion of a display according to an embodiment of the disclosure is accommodated in a housing. FIG. 2 is a view illustrating the state in which a second display area (e.g., the display area A2 in FIG. 3) of a display is accommodated according to an embodiment of the disclosure in the housing. FIG. 3 is a view illustrating the state in which a portion of a display according to an embodiment of the disclosure is exposed to the outside of the housing. FIG. 3 is a view illustrating the state in which the second display area of the display according to an embodiment of the disclosure is exposed to the outside of the housing.

FIGS. 2 and 3 illustrate a structure in which a display 203 (e.g., a flexible display or rollable display) is expanded in the longitudinal direction (e.g., the +Y direction) when viewed from the front of the electronic device 101. However, the expansion direction of the display 203 is not limited to one direction (e.g., the +Y direction). For example, a design change may be made such that the display 203 can be expanded upward (e.g., in the +Y direction), rightward (e.g., in the +X direction), leftward (e.g., in the -X direction), and/or downward (e.g., in the -Y direction).

The state illustrated in FIG. 2 may be referred to as a slid-in state of the electronic device 101 or a state in which the second display area A2 of the display 203 is closed.

The state illustrated in FIG. 3 may be referred to as a slid-out state of the electronic device 101 or a state in which the second display area A2 of the display 203 is opened.

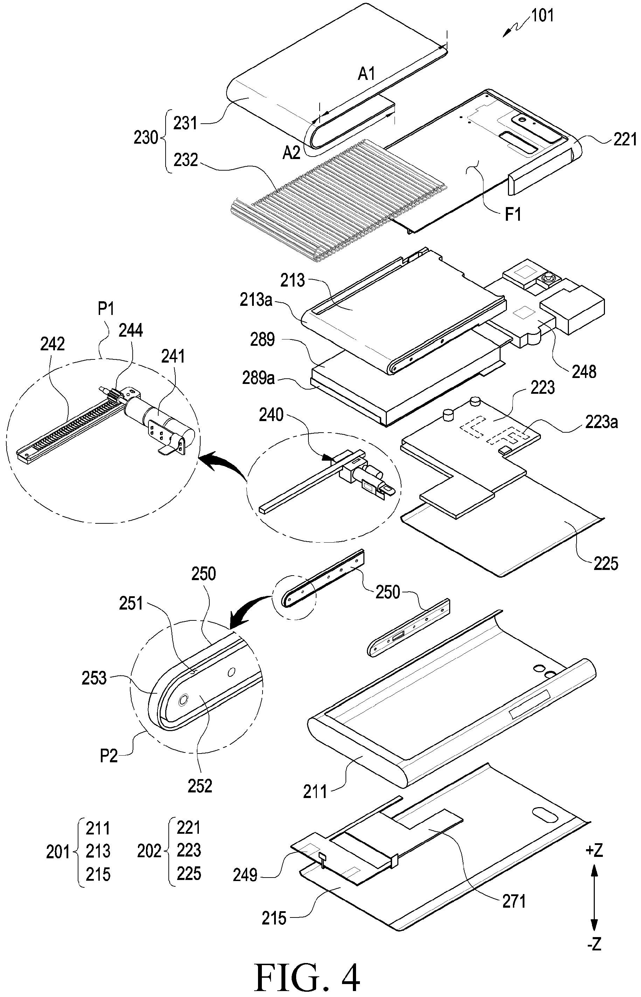

The embodiment of FIGS. 2 and 3 may be combined with the embodiment of FIG. 1 or the embodiments of FIGS. 4 to 14C.

Referring to FIGS. 2 and 3, the electronic device 101 (e.g., the electronic device 101 in FIG. 1) may include a housing 210. The housing 210 may include a first housing 201 and a second housing 202 disposed to be movable relative to the first housing 201. In an embodiment, the electronic device 101 may be interpreted as having a structure in which the first housing 201 is disposed to be slidable relative to the second housing 202. According to an embodiment, the second housing 202 may be disposed to be reciprocal by a predetermined distance in the illustrated direction (e.g., the direction indicated by arrow η) relative to the first housing 201.

According to an embodiment, the second housing 202 may be referred to as a slide portion or a slide housing and may be movable relative to the first housing 201. According to an embodiment, the second housing 202 may accommodate various electrical and electronic components such as a circuit board and a battery. When the electronic device 101 is in the slid-in state, the second housing 202 may be defined as being in a retracted position, and when the electronic device 101 is in the slid-out state, the second housing 202 may be defined as being in an expanded position.

According to an embodiment, the slid-in state of the electronic device 101 (or the slid-out state of the electronic device 101) may be changed into the slid-out state of the electronic device 101 (or the slid-in state of the electronic device 101) based on a predefined user input. For example, the slid-in state of the electronic device 101 (or the slid-out state of the electronic device 101) may be changed into the slid-out state (or the slid-in state of the electronic device 101) in response to a user input on a physical button which is exposed through a portion of the first housing 201 or a portion of the second housing 202. For example, the slid-in state (or the slid-out state of the electronic device 101) may be changed into the slid-out state (or the slid-in state of the electronic device 101) in response to a touch input on an executable object displayed within a screen display area (e.g., the first display area A1). For example, the slid-in state (or the slid-out state of the electronic device 101) may have a contact point on the screen display area (e.g., the first display area A1) and may be changed into the slid-out state (or the slid-in state of the electronic device 101) in response to a touch input having a pressing intensity greater than a reference intensity. For example, the slid-in state (or the slid-out state of the electronic device 101) may be changed into the slid-out state (or the slid-in state of the electronic device 101) in response to a voice input received through a microphone of the electronic device 101. For example, the slid-in state (or the slid-out state of the electronic device 101) may be changed to the slid-out state (or the slid-in state of the electronic device 101) in response to an external force applied to the first housing 201 and/or the second housing 202 in order to move the second housing 202 relative to the first housing 201. For example, the slid-in state (or the slid-out state of the electronic device 101) may be changed to the slid-out state (or the slid-in state of the electronic device 101) in response to a user input identified by an external electronic device (e.g., earbuds or smartwatch) connected to the electronic device 101. However, the slid-in/out operation of the electronic device 101 is not limited to these.

According to an embodiment, the first housing 201 may accommodate an actuator (e.g., a motor), a speaker, a SIM socket, and/or a sub-circuit board electrically connected to a main circuit board. The second housing 202 may accommodate the main circuit board mounted with electrical components such as an application processor (AP) and a communication processor (CP). According to an embodiment, the second housing 202 may accommodate an actuator, a speaker, a SIM socket, and/or a sub-circuit board electrically connected to the main circuit board, and the first housing 201 may accommodate a main circuit board mounted with electrical components such as an application processor (AP) and a communication processor (CP). According to an embodiment, the sub-circuit board and the main circuit board may be disposed in the first housing 201 or in the second housing 202.

According to an embodiment, the first housing 201 may include a first cover member 211 (e.g., a main case). The first cover member 211 may include a (1-1)^{th} side wall 211a, a (1-2)^{th} side wall 211b extending from the (1-1)^{th} side wall 211a, and a (1-3)^{th} side wall 211a extending from the (1-1)^{th} side wall 211c substantially parallel to the (1-2)^{th} side wall 211b. According to an embodiment, the (1-2)^{th} side wall 211b and the (1-3)^{th} side wall 211c may be substantially perpendicular to the (1-1)^{th} side wall 211a.

According to an embodiment, the (1-1)^{th} side wall 211a, the (1-2)^{th} side wall 211b, and the (1-3)^{th} side wall 211c of the first cover member 211 may have a shape that is open on one side (e.g., the front surface) to accommodate (or surround) at least a portion of the second housing 202. For example, at least a portion of the second housing 202 may be surrounded by the first housing 201 and may be slid in a direction parallel to a first surface (e.g., the first surface F1 in FIG. 4) (e.g., the direction indicated by arrow ①) while being guided by the first housing 201. According to an embodiment, the (1-1)^{th} side wall 211a, the (1-2)^{th} side wall 211b, and/or the (1-3)^{th} side wall 211c of the first cover member 211 may be integrally configured. According to an embodiment, the (1-1)^{th} side wall 211a, the (1-2)^{th} side wall 211b, and/or the (1-3)^{th} side wall 211c of the first cover member 211 may be provided as separate structures and coupled or assembled to each other.

According to an embodiment, the first cover member 211 may be configured to surround at least a portion of a display 203. For example, the display 203 may be provided to be at least partially surrounded by the (1-1)^{th} side wall 211a, the (1-2)^{th} side wall 211b, and/or the (1-3)^{th} side wall 211c of the first cover member 211.

According to an embodiment, the second housing 202 may include a second cover member 221 (e.g., a slide plate). The second cover member 221 may have a plate shape and include a first surface (e.g., the first surface F1 in FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a (2-1)^{th} side wall 221a, a (2-2)^{th} side wall 221b extending from the (2-1)^{th} side wall 221a, and a (2-3)^{th} side wall 221c extending from the (2-1)^{th} side wall 221a substantially parallel to the (2-2)^{th} side wall 221b. According to an embodiment, the (2-2)^{th} side wall 221b and the (2-3)^{th} side wall 221c may be substantially perpendicular to the (2-1)^{th} side wall 221a.

According to various embodiments, as the second housing 202 moves in a first direction (e.g., direction ①) parallel to the (2-2)^{th} side wall 221b or the (2-3)^{th} side wall 221c, the electronic device 101 may be in the slid-in state and the slid-out state. In the slid-in state of the electronic device 101, the second housing 202 is located at a first distance from the (1-1)^{th} side wall 211a of the first housing 201, and in the slid-out state of the electronic device 101, the second housing 202 may be moved to be located at a second distance greater than the first distance from the (1-1)^{th} side wall 211a of the first housing 201. In an embodiment, in the slid-in state of the electronic device 101, the first housing 201 may be configured to partially surround the (2-2)^{th} side wall 221b and the (2-3)^{th} side wall 221c.

According to an embodiment, the electronic device 101 may be in an intermediate state between the slid-in state of FIG. 2 (e.g., the fully closed state) and the slid-out state of FIG. 3 (e.g., the fully opened state). The distance between the (1-1)^{th} side wall 211a and the (2-1)^{th} side wall 221a in the intermediate state of the electronic device 101 may be smaller than the distance between the (1-1)^{th} side wall 211a and the (2-1)^{th} side wall 211a of the electronic device 101 in the fully opened state and may be greater than the distance between the (1-1)^{th} side wall 211a and the (2-1)^{th} side wall 221a of the electronic device 101 in the fully closed state. According to an embodiment, as at least a portion of the display 203 slides in the intermediate state of the electronic device 101, the area of the display exposed to the outside may be variable. For example, in the intermediate state of the electronic device 101, the ratio of the width (the length in the X direction) and the height (the length in the Y direction) of the display 203 and/or the distance between the (1-1)^{th} side wall 211a and the (2-1)^{th} side wall 221a may be changed based on the slide movement of the electronic device 101.

According to an embodiment, the electronic device 101 may include a display 203, a key input device 245, a connector hole 243, audio modules 247a and 247b, or camera modules 249a and 249b. According to an embodiment, the electronic device 101 may further include an indicator (e.g., an LED device) or various sensor modules.

According to an embodiment, the display 203 may be configured such that the size of a portion visible from the front side of the housing 210 is changed based on the slide movement of the second housing 202. According to an embodiment, the display 203 may include a first display area A1 and a second display area A2 configured to be exposed to the outside of the electronic device 101 based on the slide movement of and the second housing 202.

According to an embodiment, the first display area A1 may be disposed on the second housing 202. For example, the first display area A1 may be disposed on the second cover member 221 of the second housing 202. According to an embodiment, the second display area A2 extends from the first display area A1, and as the second housing 202 slides relative to the first housing 201, the second display area A2 may be accommodated inside the first housing 201 or visually exposed to the outside of the electronic device 101. According to an embodiment, as the electronic device 101 is changed from the slid-in state to the slid-out state, the display 203 may be expanded in the downward direction of the electronic device 101 (e.g., the -Y direction). For example, when the electronic device 101 is in the slid-out state, the second display area A2 may be visually exposed below the display 203 (e.g., in the -Y direction). According to an embodiment, as the electronic device 101 is changed from the slid-in state to the slid-out state, the display 203 may be expanded in the upward direction of the electronic device 101 (e.g., in the +Y direction). For example, when the electronic device 101 is in the slid-out state, the second display area A2 may be visually exposed above the display 203 (e.g., in the +Y direction).

According to an embodiment, the second display area A2 may move substantially while being guided by an area of the first housing 201 (e.g., the curved surface 213a in FIG. 4), and may be accommodated in a space located inside the first housing 201 or exposed to the outside of the electronic device 101. According to an embodiment, the second display area A2 may be moved based on the slide movement of the second housing 202 in the first direction (e.g., the direction indicated by arrow η). For example, while the second housing 202 slides, a portion of the second display area A2 may be deformed into a curved shape at a position corresponding to the curved surface 213a of the first housing 201.

According to an embodiment, when viewed from above the second cover member 221 (e.g., the front cover), when the electronic device 101 is changed from the slid-in state to the slid-out state (for example, when the second housing 202 slides to be expanded with respect to the first housing 201), the second display area A2 may form a substantially flat surface together with the first display area A1 while being gradually exposed to the outside of the first housing 201. According to an embodiment, the display 203 may be coupled to or arranged adjacent to a touch-sensing circuit, a pressure sensor that is capable of measuring touch intensity (pressure), and/or a digitizer that detects a magnetic field-type stylus pen. According to an embodiment, regardless whether the electronic device 101 is in the slid-in or slid-out state, a portion of the exposed second display area A2 may be located on a portion of the first housing (e.g., the curved surface 213a in FIG. 4), and a portion of the second display area A2 may maintain the curved shape at a position corresponding to the curved surface 213a.

According to an embodiment, the key input device 245 may be located in one area of the housing 210 (e.g., the first housing 201 and/or the second housing 202). The electronic device 101 may be designed such that the illustrated key input device 245 is omitted or an additional key input device is included depending on the external appearance and use state. According to an embodiment, the electronic device 101 may include key input devices (not illustrated), such as a home key button or touch pads disposed around the home key button. According to an embodiment, at least some of the key input devices 245 may be disposed on the (1-1)^{th} side wall 211a, the (1-2)^{th} side wall 211b, or the (1-3)^{th} side wall 211c of the first housing 201. According to an embodiment, at least some of the key input devices 245 may be disposed on the (2-1)^{th} side wall 221a, the (2-2)^{th} side wall 221b, or the (2-3)^{th} side wall 221c of the second housing 202.

According to an embodiment, the connector hole 243 may be omitted in some embodiments and may accommodate a connector (e.g., a USB connector) for transmitting/receiving power and/or data to/from an external electronic device. According to an embodiment (not illustrated), the electronic device 101 may include a plurality of connector holes 243, and some of the connector holes 243 may function as connector holes for transmitting/receiving audio signals to/from an external electronic device. In the illustrated embodiment, the connector hole 243 is located in the second housing 202, but is not limited to thereto. The connector hole 243 or a connector hole (not illustrated) may be located in the first housing 201.

According to an embodiment, the audio modules 247a and 247b may include one or more speaker holes 247a or one or more microphone holes 247b. One of the speaker holes 247a may be provided as a receiver hole for a voice call, and another one may be provided as an external speaker hole. The electronic device 101 may include a microphone configured to acquire sound, and the microphone may acquire sound outside the electronic device 101 through the microphone hole 247b. According to an embodiment, the electronic device 101 may include a plurality of microphones to detect the direction of sound. According to an embodiment, the electronic device 101 may include an audio module in which the speaker hole 247a and the microphone hole 247b are implemented as a single hole, or a speaker in which the speaker holes 247a are excluded (e.g., a piezo speaker). According to an embodiment, the speaker hole 247a and the microphone hole 247b may be located in the first housing 201 and/or the second housing 202.

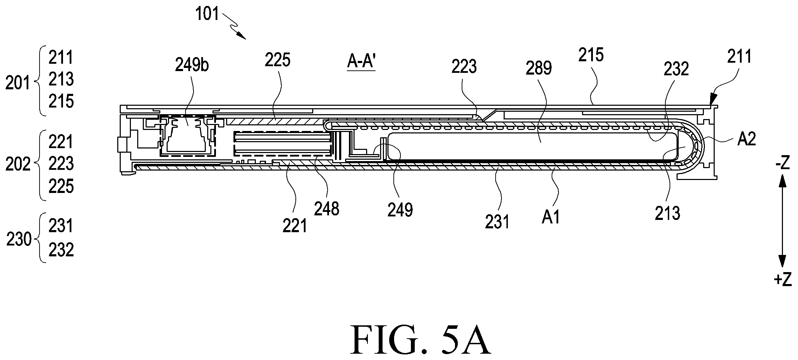

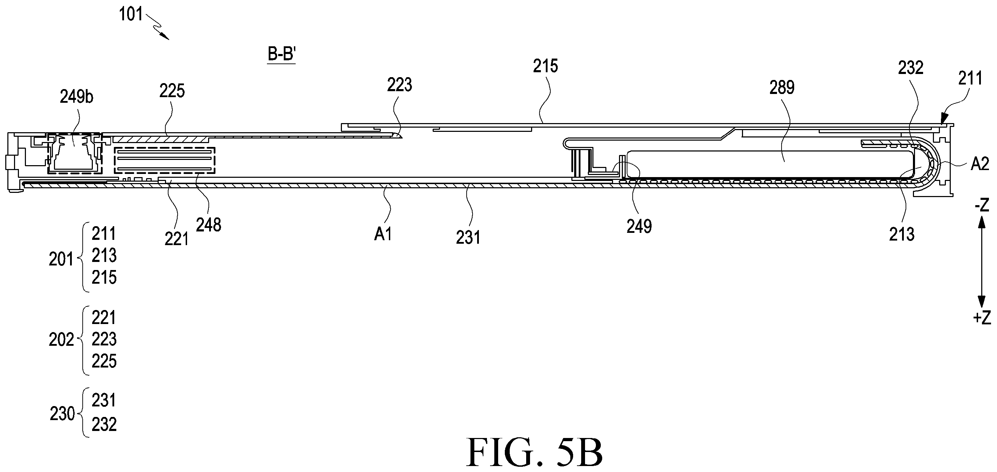

According to an embodiment, the camera modules 249a and 249b may include a first camera module 249a (e.g., a front camera) and a second camera module 249b (e.g., a rear camera) (e.g., the second camera module 249b in FIGS. 5A and 5B). According to an embodiment, the electronic device 101 may include at least one of a wide-angle camera, a telephoto camera, or a close-up camera. In some embodiments, the electronic device 101 may include an infrared projector and/or an infrared receiver to measure the distance to a subject. The camera modules 249a and 249b may include one or more lenses, image sensors, and/or image signal processors. The first camera module 249a may be disposed to be oriented in the same direction (e.g., the +Z direction in FIG. 4) as the display 203. For example, the first camera module 249a may be disposed around the first display area A1 or in an area overlapping the display 203, and when disposed in the area overlapping the display 203, the first camera module 249a may photograph a subject through the display 203. According to an embodiment, the first camera module 249a may include an under-display camera (UDC) which may be hidden without being visually exposed to a screen display area (e.g., the first display area A1). According to an embodiment, the second camera module 249b may photograph a subject in a direction (e.g., the -Z direction in FIG. 4) opposite to the first display area A1. According to an embodiment, the first camera module 249a and/or the second camera module 249b may be disposed on the second housing 202. According to an embodiment, a plurality of second camera module 249b may be provided to provide various arrangements. For example, the plurality of second camera modules 249b may be arranged along the width direction (the X-axis direction), which is a direction substantially perpendicular to the slide movement direction (e.g., the Y-axis direction) of the electronic device 101. As another example, the plurality of second camera modules 249b may be arranged along the slide movement direction (e.g., the Y-axis direction) of the electronic device 101. As another example, the plurality of second camera modules 249b may be arranged along N * M rows and columns like a matrix.

According to an embodiment, when the electronic device 101 is in the slid-in state, the second camera module 249b may not be visually exposed to the outside of the electronic device 101, and when the electronic device 101 is in the slid-out state, the second camera module 249b may photograph the outside of the electronic device 101. According to an embodiment, the second camera module 249b may photograph the outside of the electronic device 101 when the electronic device 101 is in the slid-in state and/or the slid-out state. For example, at least a portion of the housing 210 (e.g., the first rear surface plate 215 and/or the second rear surface plate 225 in FIG. 4) may be substantially transparent, and the second camera module 249b may photograph the outside of the electronic device 101 through the first rear surface plate 215 and/or the second rear surface plate 225. According to an embodiment, when the electronic device 101 is in the slid-in state and/or the slid-out state, the second camera module 249b may be visually exposed to the outside of the electronic device 101 and photograph the outside. For example, the first housing 201 (e.g., the first rear surface plate 215 in FIG. 4) may include an opening 201a for the second camera module 249b.

According to an embodiment, an indicator (not illustrated) of the electronic device 101 may be disposed on the first housing 201 or the second housing 202 and may include a light-emitting diode to provide state information of the electronic device 101 as a visual signal. The sensor modules 261a and 261b of the electronic device 101 may generate electrical signals or data values corresponding to an internal operating state of the electronic device 101 or an external environmental state. The sensor modules 261a and 261b may include, for example, a proximity sensor, a fingerprint sensor, and/or a biometric sensor (e.g., an iris/face recognition sensor or an HRM sensor). In an embodiment the sensor modules 261a and 261b may further include at least one of a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor. According to an embodiment, the sensor modules 261a and 261b may be disposed in the first housing 201 and/or the second housing 202. For example, the sensor modules 261a and 261b may include, for example, a first sensor module 261a (e.g., a proximity sensor or an illuminance sensor) disposed on the front surface of the electronic device 101 and/or a second sensor module 261b (e.g., a heart rate monitoring (HRM) sensor) disposed on the rear surface of the electronic device 101.

FIG. 4 is an exploded perspective view of an electronic device according to an embodiment of the disclosure.

FIG. 5A is a cross-sectional view of an embodiment of the disclosure, taken along line A-A' in FIG. 2.

FIG. 5B is a cross-sectional view of an embodiment of the disclosure, taken along line B-B' in FIG. 3.

Referring to FIGS. 4, 5A, and/or 5B, the electronic device 101 (e.g., the electronic device 101 in FIGS. 1 to 3) may include a first housing 201, a second housing 202, a display assembly 230, and a driving structure 240. The components of the first housing 201, the second housing 202, and the display assembly 230 of FIG. 4, FIG. 5A and/or FIG. 5B may be wholly or partly the same as those of the first housing 201, the second housing 202, and the display 203 of FIG. 2 and/or FIG. 3.

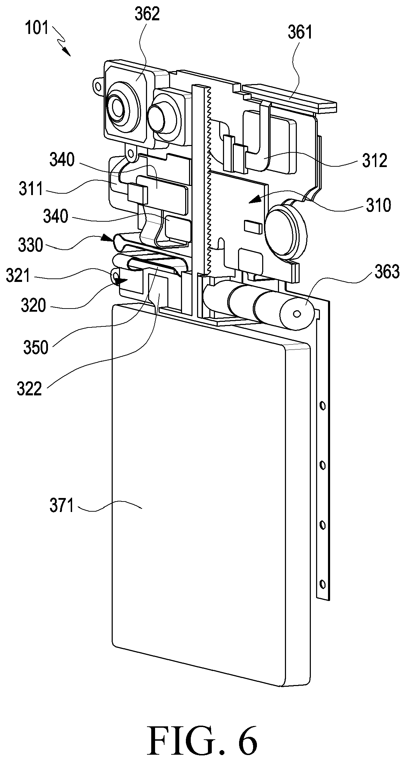

The embodiments of FIGS. 4 to 5B may be partially combined with the embodiments of FIGS. 1 to 3 or the embodiments of FIGS. 6 to 14C.

According to an embodiment, the first housing 201 may include a first cover member 211 (e.g., the first cover member 211 in FIGS. 2 and 3), a frame 213, and a first rear surface plate 215.

According to an embodiment, the first cover member 211 may accommodate at least a portion of the frame 213 and a component (e.g., the battery 289) located on the frame 213. According to an embodiment, the first cover member 211 may be configured to surround at least a portion of a second housing 202. According to an embodiment, the first cover member 211 may protect components (e.g., the second circuit board 249 and the frame 213) located in the first housing 201 from external impact. According to an embodiment, the second circuit board 249, which is electrically connected to the electrical components (e.g., an actuator, a speaker, a shim socket, and/or the first circuit board 248), may be connected to the first cover member 211.

According to an embodiment, the frame 213 may be connected to the first cover member 211. For example, the frame 213 may be connected to the first cover member 211, and the second housing 202 may be relatively moved with respect to the first cover member 211 and/or the frame 213. According to an embodiment, the frame 213 may accommodate the battery 289. For example, the frame 213 may include a groove to accommodate the battery 289. The frame 213 may be connected to a battery cover 289a and may surround at least a portion of the battery 289 together with the battery cover 289a. According to an embodiment, the frame 213 may include a curved portion 213a facing the display assembly 230.

According to an embodiment, the first rear surface plate 215 may substantially define at least a portion of the exterior of the first housing 201 or the electronic device 101. For example, the first rear surface plate 215 may be coupled to the outer surface of the first cover member 211. According to an embodiment, the first rear surface plate 215 may provide a decorative effect on the exterior of the electronic device 101. The first rear surface plate 215 may be made of at least one of metal, glass, synthetic resin, or ceramic.

According to an embodiment, the second housing 202 may include a second cover member 221 (e.g., the second cover member 221 in FIGS. 2 and 3), a rear cover 223, and a second rear surface plate 225.

According to an embodiment, the second cover member 221 may be connected to the first housing 201 via a guide rail 250, and may linearly reciprocate in in one direction (e.g., the direction indicated by arrow ① in FIG. 3) while being guided by the guide rail 250.

According to an embodiment, the second cover member 221 may be configured to support at least a portion of the display 231. For example, the second cover member 221 may include a first surface F1, and the first display area A1 of the display 231 may be substantially located on the first surface F1 and maintained in a flat plate shape. According to an embodiment, the second cover member 221 may be made of a metal material and/or a non-metal (e.g., polymer) material. According to an embodiment, the first circuit board 248, which accommodates electronic components (e.g., the processor 120 and/or the memory 130 in FIG. 1), may be connected to the second cover member 221. According to an embodiment, the second cover member 221 may protect components (e.g., the first circuit board 248 and the rear cover 223) located in the second housing 202 from external impact.

According to an embodiment, the rear cover 223 may protect components (e.g., the first circuit board 248) located on the second cover member 221. For example, the rear cover 223 may be connected to the second cover member 221 and surround at least a portion of the first circuit board 248. According to an embodiment, the rear cover 223 may include an antenna pattern (e.g., at least one antenna element 223a) configured to communicate with an external electronic device. For example, when the rear cover 223 is an injection molded product (e.g., an antenna carrier) of a dielectric material, the at least one antenna element 223a may be disposed on the outer surface (e.g., the surface oriented in the -Z-axis direction) of the rear cover 223. For example, the at least one antenna element 224b may include a laser direct structuring (LDS) antenna pattern provided on the outer surface of the rear cover 223. For example, the at least one antenna element 223a may be provided in the manner of being embedded in the rear cover 223 when the rear cover is molded. For example, the at least one antenna element 223a may be configured to transmit or receive a wireless signal in a predetermined frequency band (e.g., a legacy band) by being electrically connected to a wireless communication circuit (e.g., the wireless communication module 192 in FIG. 1) disposed on the first circuit board 248.

According to an embodiment, the second rear surface plate 225 may substantially define at least a portion of the exterior of the second housing 202 or the electronic device 101. For example, the second rear surface plate 225 may be coupled to the outer surface of the second cover member 221. According to an embodiment, the second rear surface plate 225 may provide a decorative effect on the exterior of the electronic device 101. The second rear surface plate 225 may be made of at least one of metal, glass, synthetic resin, or ceramic.

According to an embodiment, the display assembly 230 may include a display 231 (e.g., display 203 in FIGS. 2 and/or 3) and a multi-bar structure 232 supporting the display 231. According to an embodiment, the display 231 may be referred to as a flexible display, a foldable display, and/or a rollable display. According to an embodiment, the first display area A1 of the display 231 may be supported by a rigid body, and the second display area A2 may be supported by a bendable structure. For example, the first display area A1 may be supported by the first surface F1 of the second cover member 221 or a plate (not illustrated). The second display area A2 may be supported by the multi-bar structure 232.

According to an embodiment, the multi-bar structure 232 may be connected or attached to at least a portion of the display 231 (e.g., the second display area A2). According to an embodiment, as the second housing 202 slides, the multi-bar structure 232 is movable relative to the first housing 201. When the electronic device 101 is in the slid-in state (e.g., FIG. 2), the multi-bar structure 232 may be mostly accommodated inside the first housing 201, and may be located between the first cover member 211 and the second cover member 221. According to an embodiment, at least a portion of the multi-bar structure 232 may move to correspond to the curved surface 213a located at an edge of the frame 213. According to an embodiment, the multi-bar structure 232 may be referred to as a display support member or support structure, and may be in the form of an elastic plate.

According to an embodiment, the drive structure 240 may relatively move the second housing 202 relative to the first housing 201. For example, the drive structure 240 may include an actuator 241 configured to generate a driving force for slide movement of the second housing 202 relative to the first housing 201. The drive structure 240 may include a gear 244 (e.g., a pinion) connected to the actuator 241 and a rack 242 configured to be engaged with the gear. Referring to FIG. 4, the components (e.g., the actuator 241, the rack 242, and the gear 244) of the drive structure 240, which are inverted (e.g., facing the -Z axis direction), are illustrated within the circle P1.

According to an embodiment, the housing in which the rack 242 is located and the housing in which the actuator 241 is located may be different. According to an embodiment, the actuator 241 may be connected to the first housing 201, and the rack 242 may be connected to the second housing 202. According to an embodiment, the actuator 241 may be connected to the second housing 202, and the rack 242 may be connected to the first housing 201.

According to an embodiment, the actuator 241 may be controlled by a processor (e.g., the processor 120 in FIG. 1). For example, the processor 120 may include an actuator driver driving circuit and deliver a pulse width modulation (PWM) signal to the actuator 241 to control the speed of the actuator 241 and/or the torque of the actuator 241. According to an embodiment, the actuator 241 may be electrically connected to a processor (e.g., the processor 120 in FIG. 1) located on a circuit board (e.g., the first circuit board 248 in FIG. 4) via a flexible printed circuit board.

According to an embodiment, the second housing 202 may accommodate a first circuit board 248 (e.g., a main board). According to an embodiment, a processor, memory, and/or an interface may be mounted on the first circuit board 248. The processor may include one or more of, for example, a central processing unit, an application processor, a graphics processing unit, an image signal processor, a sensor hub processor, or a communication processor. According to various embodiments, the first circuit board 248 may include a flexible printed circuit board-type radio frequency cable (FRC). The first circuit board 248 may be disposed on at least a portion of the second cover member 221, and electrically connected to an antenna module (e.g., the antenna module 197 in FIG. 1) and a communication module (e.g., the communication module 190 in FIG. 1).

According to an embodiment, the memory may include, for example, volatile memory or nonvolatile memory.

According to an embodiment, the interface may include, for example, a high-definition multimedia interface (HDMI), a universal serial bus (USB) interface, an SD card interface, and/or an audio interface. For example, the interface may electrically or physically connect the electronic device 101 to an external electronic device and include a USB connector, an SD card/MMC connector, or an audio connector.

According to an embodiment, the electronic device 101 may include a first circuit board 248 (e.g., a main circuit board) and a second circuit board 249 (e.g., a sub-circuit) spaced apart from each other within the first housing 201. The second circuit board 249 may be electrically connected to the first circuit board 248 via a flexible board. The second circuit board 249 may be electrically connected to the battery 289 or electrical components disposed in an end area of the electronic device 101, such as a speaker and/or a SIM socket, to transmit signals and power. According to an embodiment, the second circuit board 249 may accommodate an antenna member 271 (e.g., a coil) or be connected to the antenna member 271. The antenna member 271 may include an MFC (multifunction coil) antenna including a wireless charging antenna for a wireless charging function, a neat field communication (NFC) antenna for a neat field communication function and/or a magnetic secure transmission (MST) antenna for an electronic payment function. For example, the battery 289 may receive power from an external electronic device by using the antenna member 271 for wireless charging. As another example, the battery 289 may deliver power to an external electronic device by using the antenna member 271 for wireless charging.

According to an embodiment, the battery 289 is a device configured to supply power to at least one component of the electronic device 101, and may include, for example, a non-rechargeable primary battery, a rechargeable secondary battery, or a fuel cell. The battery 289 may be integrally disposed inside the electronic device 101 or may be detachably disposed on the electronic device 101. According to an embodiment, the battery 289 may be configured as a single integrated battery or may include a plurality of separable batteries. According to an embodiment, the battery 289 may be located on the frame 213. For example, the battery 289 may be surrounded by the frame 213 and the battery cover 289a. According to an embodiment, the battery may be located within the second housing 202 to be slidable with the second housing 202.

According to an embodiment, the guide rail 250 may guide the movement of the multi-bar structure 232. For example, the multi-bar structure 232 may slide along the slit 251 provided in the guide rail 250. According to an embodiment, the guide rail 250 may be connected to the first housing 201. For example, the guide rail 250 may be connected to the first cover member 211 and/or the frame 213. According to an embodiment, the slit 251 may be referred to as a groove or recess provided on the inner surface of the guide rail 250. Referring to FIG. 4, the guide rail 250 is enlarged and illustrated within the circle P2.

According to an embodiment, the guide rail 250 may provide a force to the multi-bar structure 232 based on the driving of the actuator 241.

According to an embodiment, when the electronic device 101 is changed from the slid-in state to the slid-out state, at least a portion of the second housing 202 may slide to be exposed to the outside from the first housing 201 through the driving of the actuator 241. For example, the gear 244 may rotate in a first rotation direction based on the driving of the actuator 241. As the rack 242 is fixed on the second cover member 221 of the second housing 202, the second housing 202 may slide to be exposed to the outside of the first housing 201 based on the slide movement of the rack 242 toward the slid-out direction.

According to an embodiment, when the electronic device 101 is changed from the slid-in state to the slid-out state, the inner portion 252 of the guide rail 250 may provide a force to the multi-bar structure 232. The multi-bar structure 232, which has received the force, may move along the slit 251 of the guide rail 250, and the second housing 202 may slide so as to be expanded with respect to the first housing 201. At least a portion of the display assembly 230 accommodated between the first cover member 211 and the frame 213 may be expanded to the front surface.

According to an embodiment, when the electronic device 101 is changed from the slid-out state to the slid-in state, at least a portion of the second housing 202 may slide to be inserted into the first housing 201 through the driving of the actuator 241. For example, the gear 244 may rotate in a second rotation direction opposite to the first rotation direction based on the driving of the actuator 241. As the rack 242 is fixed on the second cover member 221 of the second housing 202, the second housing 202 may slide to enter the inside of the first housing 201 based on the slide movement of the rack 242 toward the slid-in direction.

According to an embodiment, when the electronic device 101 is changed from the slid-out state to the slid-in state, the outer portion 253 of the guide rail 250 may provide a force to the bent multi-bar structure 232. The multi-bar structure 232, which has received the force, may move along the slit 251 of the guide rail 250, and the second housing 202 may slide so as to be at least partially accommodated in the first housing 201. At least a portion of the display assembly 230 may be accommodated between the first cover member 211 and the frame 213.

According to an embodiment, the electronic device 101 may be configured to stop in a predetermined intermediate state between the slid-in state and the slid-out state by controlling the driving of the actuator 241 (a free stop function). According to an embodiment, the electronic device 101 may be changed to the slid-in state, the intermediate state, or the slid-out state through a user's manipulation while no driving force is provided to the actuator 241.

Referring to FIG. 5A, when the electronic device 101 is in the slid-in state, at least a portion of the second housing 202 may be arranged to be accommodated in the first housing 201. As the second housing 202 is arranged to be accommodated in the first housing 201, the overall volume of the electronic device 101 may be reduced. According to an embodiment, when the second housing 202 is accommodated in the first housing 201, the visually exposed size of the display 231 may be minimized. For example, when the second housing 202 is fully accommodated in the first housing 201, the first display area A1 of the display 231 is visually exposed, and at least a portion of the second display area A2 (e.g., the portion oriented in the -Z axis direction) may be disposed between the battery 289 and the first rear surface plate 215.

Referring to FIG. 5B, when the electronic device 101 is in the slid-out state, at least a portion of the second housing 202 may be arranged to protrude from the first housing 201. As the second housing 202 protrudes from the first housing 201, the overall volume of the electronic device 101 may be reduced. According to an embodiment, when the second housing 202 protrudes from the first housing 201, at least a portion of the second display area A2 of the display 231 may be visually exposed to the outside of the electronic device 101 together with the first display area A1.

According to an embodiment, one element may be formed on another element. One element may be formed at a predetermined location. The expression "formed" may be replaced with the expression "composed", "disposed", or "located".

According to an embodiment, one element may be coupled to another element. The expression "coupled" may be replaced with the expression "adhesive" or "joined". The term "coupled" may be "being bonded by an adhesive or an adhesive layer".

According to an embodiment, one element may be dislocated from another element. The term "dislocated" may mean that "one element does not face another element". The term "dislocated" may mean that "one element does not match the other element". The term "dislocated" may mean that "the one element and the other element are not aligned". The term "dislocated" may mean that "the one element and the other element do not overlap each other". For example, the expression "a first boundary portion and a second boundary portion are dislocated from each other" may be replaced with the expression "the first boundary portion and the second boundary portion do not face each other", "the first boundary portion and the second boundary portion do not match", "the first boundary portion and the second boundary portion are not aligned", or "the first boundary portion and the second boundary portion do not overlap".

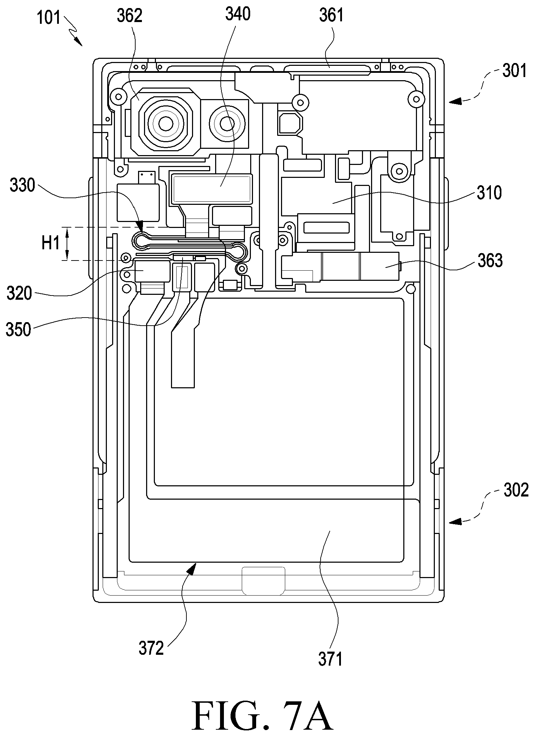

FIG. 6 is a view illustrating a portion of an electronic device according to an embodiment of the disclosure. FIG. 6 is a view illustrating an electronic device 101 with some components being separated. The components to be described with reference to FIG. 6 may be partly or wholly the same as the components described with reference to FIGS. 1 to 5B. The components to be described with reference to FIG. 6 may be partly or wholly the same as the components to be described with reference to FIGS. 7A to 14C.

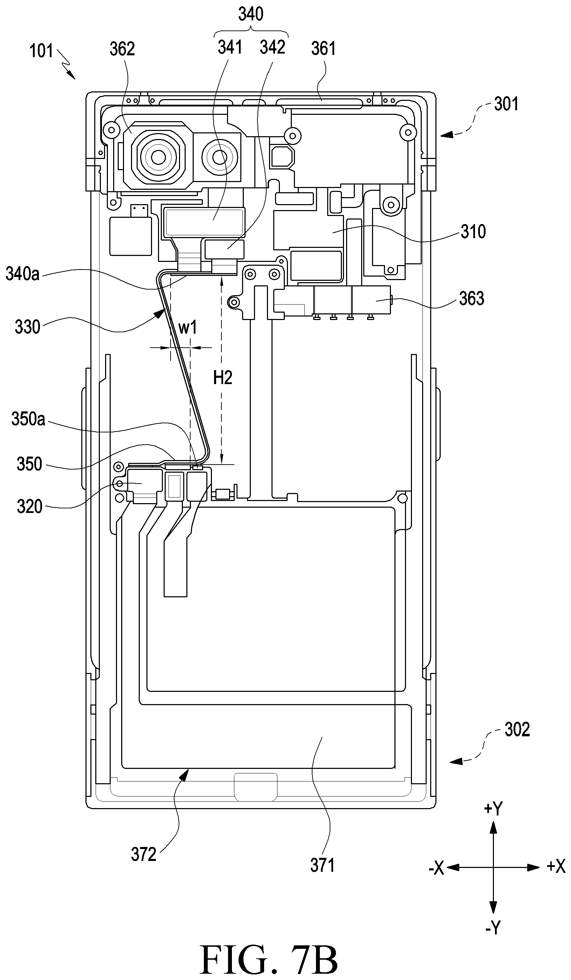

According to an embodiment, the electronic device 101 may include a first circuit board 310. The first circuit board 310 may be disposed inside a first housing (e.g., the first housing 301 in FIGS. 7A and 7B). The first circuit board 310 may be moved together with the first housing 301. The first circuit board 310 may be a printed circuit board (PCB).

According to an embodiment, the electronic device 101 may include a second circuit board 320. The second circuit board 320 may be disposed inside a second housing (e.g., the first housing 302 in FIGS. 7A and 7B). The second circuit board 320 may be fixed inside the second housing 302. The second circuit board 320 may be a printed circuit board (PCB). The second circuit board 320 may be electrically connected to the first circuit board 310.

According to an embodiment, the electronic device 101 may include a flexible circuit board 330. The flexible printed circuit board 330 may electrically connect the first circuit board 310 and the second circuit board 320. At least a portion of the flexible circuit board 330 may be deformable. The flexible circuit board 330 may extend between the first circuit board 310 and the second circuit board 320. A portion of the flexible printed circuit board 330 may be located corresponding to the first housing (e.g., the first housing 301 in FIGS. 7A and 7B), and the remainder of the flexible printed circuit board 330 may be located corresponding to the second housing (e.g., the second housing 302 in FIGS. 7A and 7B). The flexible circuit board 330 may be deformed in response to the movement of the first and second housings 301 and 302.

According to an embodiment, the electronic device 101 may include a first connector 340. The first connector 340 may connect the first circuit board 310 and the flexible circuit board 330. The first connector 340 may be disposed inside a first housing (e.g., the first housing 301 in FIGS. 7A and 7B). The first connector 340 may be moved together with the first housing 301.

According to an embodiment, the electronic device 101 may include a second connector 350. The second connector 350 may connect the second circuit board 320 and the flexible circuit board 330. The second connector 350 may be disposed inside a second housing (e.g., the second housing 302 in FIGS. 7A and 7B). The second connector 350 may be fixed inside the second housing 302.

According to an embodiment, the electronic device 101 may include a first antenna 361. The first antenna 361 may be disposed in the first housing (e.g., the first housing 301 in FIGS. 7A and 7B). The first antenna 361 may form at least a portion of the surface of the first housing 301. The first antenna 361 may move together with the first housing 301. The first antenna 361 may be electrically connected to the first circuit board 310. The electronic device 101 may include a first connection line 312 that connects the first antenna 361 and the first circuit board 310.

According to an embodiment, the electronic device 101 may include a camera assembly 362. The camera assembly 362 may be disposed in the first housing (e.g., the first housing 301 in FIGS. 7A and 7B). The camera assembly 362 may be disposed inside the first housing 301. The camera assembly 362 may move together with the first housing 301. The camera assembly 362 may be electrically connected to the first circuit board 310. The electronic device 101 may include a second connection line 311 that connects the camera assembly 362 and the first circuit board 310. The second connection line 311 may connect the first circuit board 310 and a display (e.g., the display 230 in FIG. 4).

According to an embodiment, the electronic device 101 may include an actuator 363. The actuator 363 may be disposed in the first housing (e.g., the first housing 301 in FIGS. 7A and 7B). The actuator 363 may move together with the first housing 301. The actuator 363 may be electrically connected to the first circuit board 310. The actuator 363 may be the same as the actuator 241 described with reference to FIGS. 2 to 5B.

According to an embodiment, the electronic device 101 may include a battery 371. The battery 371 may be disposed inside the second housing (e.g., the second housing 302 in FIGS. 7A and 7B). The battery 371 may be electrically connected to the second circuit board 320. The electronic device 101 may include a third connection line 322 that connects the battery 371 and the second circuit board 320. The electronic device 101 may include a fourth connection line 321 that connects a second antenna (e.g., the second antenna 372 in FIGS. 7A and 7B) and the second circuit board 320.

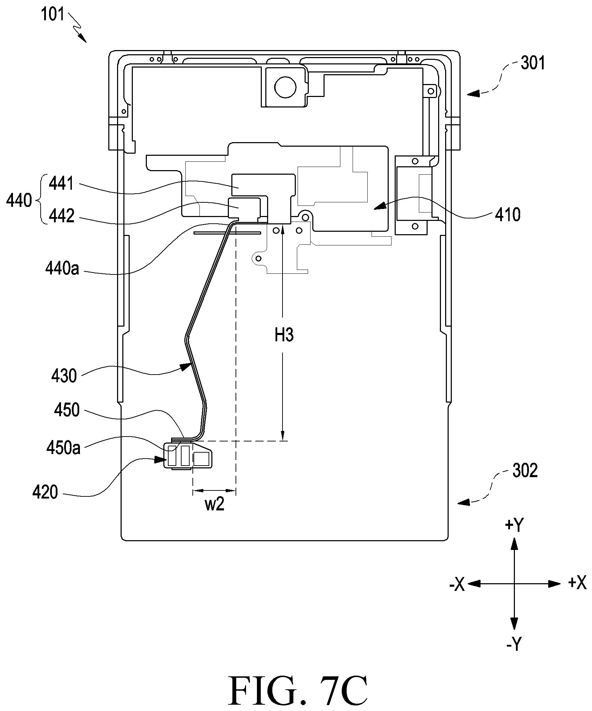

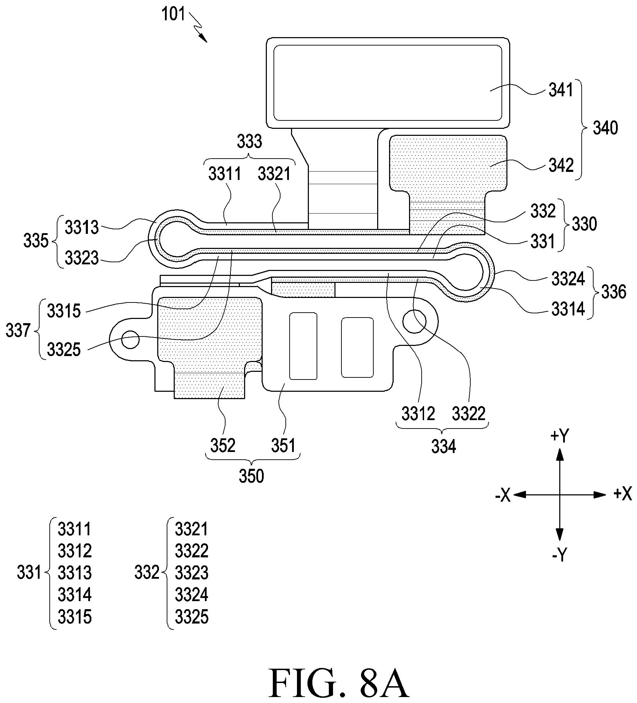

FIG. 7A is a view illustrating a portion of an electronic device according to an embodiment of the disclosure. FIG. 7A is a perspective view of the internal structure of the electronic device 101 according to an embodiment of the disclosure when the first housing 301 is drawn into the second housing 302. FIG. 7B is a view illustrating a portion of an electronic device according to an embodiment of the disclosure. FIG. 7B is a perspective view of the internal structure of the electronic device 101 according to an embodiment of the disclosure when the first housing 301 is pulled out from the second housing 302. FIG. 7C is a view illustrating a portion of an electronic device according to an embodiment of the disclosure. FIG. 7C is a perspective view of the internal structure of the electronic device 101 according to an embodiment of the disclosure when the first housing 301 is pulled out from the second housing 302. The components to be described with reference to FIGS. 7A to 7C may be partly or wholly the same as the components described with reference to FIGS. 1 to 6. The components to be described with reference to FIGS. 7A to 7C may be partly or wholly the same as the components to be described with reference to FIGS. 8A to 14C.

According to an embodiment, the first housing 301 may be disposed to be movable from the second housing 302. The first housing 301 may be inserted into the second housing 302, as illustrated in FIG. 7A. The first housing 301 may be pulled out from the second housing 302, as illustrated in FIG. 7B. The first housing 301 to be described with reference to FIGS. 6 to 14C may be the same as the second housing 202 described with reference to FIGS. 1 to 5B. The second housing 302 to be described with reference to FIGS. 6 to 14C may be the same as the first housing 201 described with reference to FIGS. 1 to 5B. The description of the coupling relationship and movement method between the first housing 201 and the second housing 202 described with reference to FIGS. 1 to 5B is equally applicable to the coupling relationship and movement method of the first housing 301 and the second housing 302 to be described with reference to FIGS. 6 to 14C.

According to an embodiment, the first circuit board 310, the first connector 340, the first antenna 361, the camera assembly 362, and the actuator 363 may move together with the first housing 301. When changing from the state of FIG. 7A to the state of FIG. 7B, the components disposed inside the first housing 301 and the second housing 302 (e.g., the first circuit board 310, the first connector 340, the first antenna 361, the camera assembly 362, and the actuator 363) may move in a first direction (e.g., the +Y direction). When changing from the state of FIG. 7B to the state of FIG. 7A, the components disposed inside the first housing 301 and the second housing 302 (e.g., the first circuit board 310, the first connector 340, the first antenna 361, the camera assembly 362, and the actuator 363) may move in a second direction (e.g., the -Y direction) opposite to the first direction (e.g., the +Y direction).

According to an embodiment, the second circuit board 320, the second connector 350, the battery 371, and the second antenna 372 may be disposed at fixed positions in the second housing 302. When changing to each of the states of FIGS. 7A and 7B, the second housing 302 and the components disposed inside the second housing 302 (e.g., the second circuit board 320, the second connector 350, the battery 371, and the second antenna 372) may not move. The electronic device 101 may include the second antenna 372. The second antenna 372 may form at least a portion of the surface of the second housing 302. The second antenna 372 may be electrically connected to the second circuit board 320.

According to an embodiment, the flexible circuit board 330 may connect the first circuit board 310 and the second circuit board 320. A portion of the flexible circuit board 330 may be located inside the first housing 301, and the remainder may be located inside the second housing 302. The flexible circuit board 330 may be deformed in response to the movement of the first housing 301. For example, when changing from the state of FIG. 7A to the state of FIG. 7B, the flexible printed circuit board 330 may be unfolded along the first direction (e.g., the +Y direction). For example, when changing from the state of FIG. 7B to the state of FIG. 7A, the flexible printed circuit board 330 may be bent along the second direction (e.g., the -Y direction). The height difference H1 between the first connector 340 and the second connector 350 in the state of FIG. 7A may be smaller than the height difference H2 between the first connector 340 and the second connector 350 in the state of FIG. 7B. The height difference H1 between the first connector 340 and the second connector 350 in the state of FIG. 7A may be smaller than the height difference H3 between the first connector 440 and the second connector 450 in the state of FIG. 7C.

According to an embodiment, the flexible circuit board 330 may have a different deformed shape depending on where the flexible circuit board is connected to the first circuit board 310 and the second circuit board 320, respectively. For example, referring to FIG. 7B, the first connector 340 may include a first connection portion 340a connected to the flexible printed circuit board 330, and the second connector 350 may include a second connection portion 350a connected to the flexible printed circuit board 330. Referring to FIG. 7B, the first connection portion 340a may be located farther apart in a third direction (e.g., the -X direction) than the second connection portion 350a. Referring to FIG. 7B, the second connection portion 350a may be located farther in a fourth direction (e.g., the +X direction) than the first connection portion 340a. The third direction (-X) and the fourth direction (+X) may be directions that intersect the direction in which the first housing 301 moves (e.g., the +Y direction). For example, referring to FIG. 7C, the first connector 440 may include a first connection portion 440a connected to the flexible printed circuit board 430, and the second connector 450 may include a second connection portion 450a connected to the flexible printed circuit board 430. Referring to FIG. 7C, the first connection portion 440a may be located farther apart in the fourth direction (e.g., the +X direction) than the second connection portion 450a. Referring to FIG. 7C, the second connection portion 450a may be located farther in the third direction (e.g., the -X direction) than the first connection portion 440a. Referring to FIG. 7B, the first connection portion 340a may have a separation distance w1 from the second connection portion 350a in the third direction (the -X direction), and referring to FIG. 7C, the first connection portion 440a may have a separation distance w2 from the second connection portion 450a in the fourth direction (the +X direction). Due to the above-described structure, the flexible circuit boards 330 and 430 may be formed into various deformable shapes. The description of the components described with reference to FIG. 7C (e.g., the first circuit board 410, the second circuit board 420, the flexible circuit board 430, the first connector 440, the first connection portion 440a, the second connector 450, and the second connection portion 450a) may be equally applicable to the components described with reference to FIG. 7B (e.g., the first circuit board 310, the second circuit board 320, the flexible circuit board 330, the first connector 340, the first connection portion 340a, the second connector 350, and the second connection portion 350a).

According to an embodiment, the first connector 340 or 440 may include a (1-1)^{th} connector 341 or 441 and a (1-2)^{th} connector 342 or 442. The first connection portion 340a or 440a may be formed in the (1-1)^{th} connector 341 or 441.

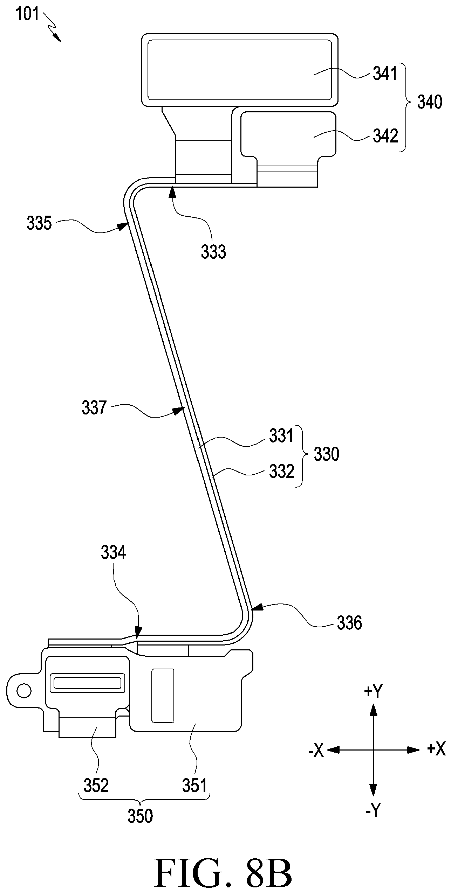

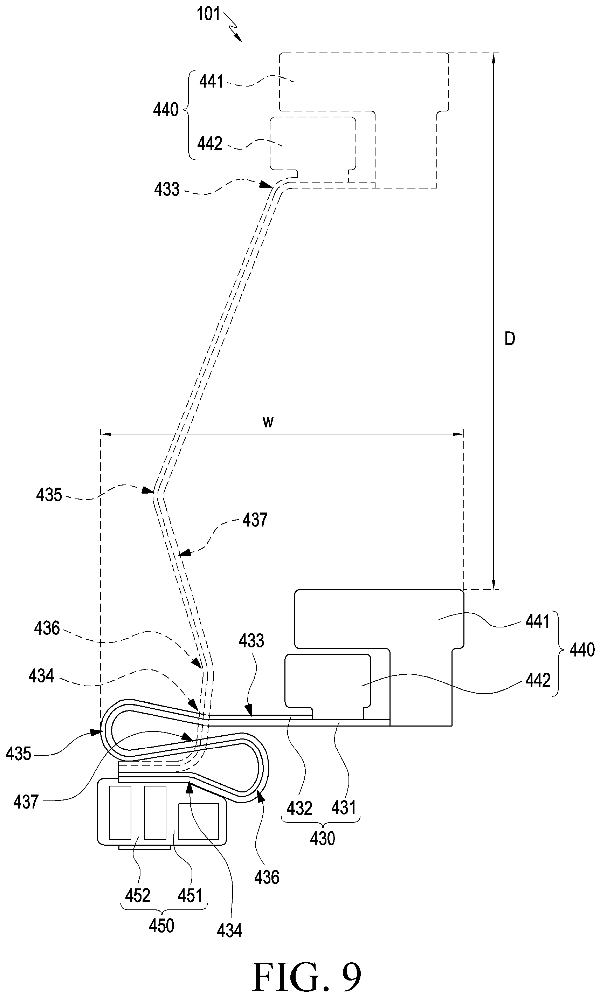

FIG. 8A is a view illustrating a portion of an electronic device according to an embodiment of the disclosure. FIG. 8A is a view illustrating the connectors 340 and 350 and the flexible circuit board 330 in the state of being separated from the state of FIG. 7A. FIG. 8B is a view illustrating a portion of an electronic device according to an embodiment of the disclosure. FIG. 8B is a view illustrating the connectors 340 and 350 and the flexible circuit board 330 in the state of being separated from the state of FIG. 7B. The components to be described with reference to FIGS. 8A and 8B may be partially or entirely the same as the components to be described with reference to FIGS. 1 to 7C. The components to be described with reference to FIGS. 8A and 8B may be partially or entirely the same as the components to be described with reference to FIGS. 9 to 14C.

According to an embodiment, the first connector 340 may include a (1-1)^{th} connector 341 and a (1-2)^{th} connector 342. The second connector 350 may include a (2-1)^{th} connector 351 and a (2-2)^{th} connector 352. The (1-1)^{th} connector 341 and the (2-1)^{th} connector 351 may be connected to each other via the first flexible circuit board 331. The (1-2)^{th} connector 342 and the (2-2)^{th} connector 352 may be connected to each other via the second flexible circuit board 332. The (1-1)^{th} connector 341 and the (1-2)^{th} connector 342 may be connected to a first circuit board (e.g., the first circuit board 310 in FIG. 6). The (2-1)^{th} connector 351 and the (2-2)^{th} connector 352 may be connected to a second circuit board (e.g., the second circuit board 320 in FIG. 6). The (1-1)^{th} connector 341 and the (2-1)^{th} connector 351 may correspond to a line that supplies power to the components of the electronic device 101, and may correspond to a line that implements an interface logic of the display assembly (e.g., the display assembly 230 in FIG. 4). The (1-2)^{th} connector 342 and the (2-2)^{th} connector 352 may correspond to an RF wire of an antenna (e.g., the first and second antennas 361 and 372 in FIGS. 6 and 7B). The (2-1)^{th} connector 351 may be connected to a battery (e.g., the battery 371 in FIG. 6) and may be connected to electronic components (e.g., a microphone, a wireless charger, and an NFC device) disposed inside a second housing (e.g., the second housing 302 in FIGS. 7A and 7B). The (2-2)^{th} connector 352 may be connected to a second antenna (e.g., the second antenna 372 in FIGS. 7A and 7B). The (1-1)^{th} connector 341 may be referred to as a "first power line". The (1-2)^{th} connector 342 may be referred to as a "first RF line". The (2-1)^{th} connector 351 may be referred to as a "second power line". The (2-2)^{th} connector 352 may be referred to as a "second RF line".

According to an embodiment, the flexible circuit board 330 may connect the first connector 340 and the second connector 350. The flexible circuit board 330 may include a first flexible circuit board 331 that connects the (1-1)^{th} connector 341 and the (2-1)^{th} connector 351. The flexible circuit board 330 may include a second flexible circuit board 332 that connects the (1-2)^{th} connector 342 and the (2-2)^{th} connector 352. The first flexible printed circuit board 331 and the second flexible printed circuit board 332 may extend parallel to each other. The first flexible circuit board 331 and the second flexible circuit board 332 may be coupled to each other or may be separated from each other.

According to an embodiment, the flexible printed circuit board 330 may include a plurality of layers. The flexible printed circuit board 330 may include a first layer 331 and a second layer 332. The first layer 331 may connect the (1-1)^{th} connector 341 and the (2-1)^{th} connector 351. The second layer 332 may connect the (1-2)^{th} connector 342 and the (2-2)^{th} connector 352. The first layer 331 and the second layer 332 may extend parallel to each other. The first layer 331 and the second layer 332 may be coupled to each other or may be separated from each other. The first layer 331 may be a first flexible printed circuit board. The second layer 332 may be a second flexible printed circuit board.

According to an embodiment, the flexible circuit board 330 may include a first rigid portion 333. The first rigid portion 333 may be connected to the first connector 340. The first rigid portion 333 includes a (1-1)^{th} rigid portion 3311 connected to the (1-1)^{th} connector 341 and a (1-2)^{th} rigid portion 3321 connected to the (1-2)^{th} connector 342. The (1-1)^{th} rigid portion 3311 may be a portion of the first flexible printed circuit board 331. The (1-2)^{th} rigid portion 3321 may be a portion of the second flexible circuit board 332.

According to an embodiment, the flexible circuit board 330 may include a second rigid portion 334. The second rigid portion 334 may be connected to the second connector 350. The second rigid portion 334 includes a (2-1)^{th} rigid portion 3312 connected to the (2-1)^{th} connector 351 and a (2-2)^{th} rigid portion 3322 connected to the (2-2)^{th} connector 352. The (2-1)^{th} rigid portion 3312 may be a portion of the first flexible printed circuit board 331. The (2-2)^{th} rigid portion 3322 may be a portion of the second flexible circuit board 332.

According to an embodiment, the flexible circuit board 330 may include a first flexible portion 335. The first flexible portion 335 may be connected to the first rigid portion 333. The first flexible portion 335 may include a (1-1)^{th} flexible portion 3313 connected to the (1-1)^{th} rigid portion 3311 and a (1-2)^{th} flexible portion 3323 connected to the (1-2)^{th} rigid portion 3321. The (1-1)^{th} flexible portion 3313 may be a portion of the first flexible printed circuit board 331. The (1-2)^{th} flexible portion 3323 may be a portion of the second flexible printed circuit board 332.

According to an embodiment, the flexible circuit board 330 may include a second flexible portion 336. The second flexible portion 336 may be connected to the second rigid portion 334. The second flexible portion 336 may include a (2-1)^{th} flexible portion 3314 connected to the (2-1)^{th} rigid portion 3312 and a (2-2)^{th} flexible portion 3324 connected to the (2-2)^{th} rigid portion 3322. The (2-1)^{th} flexible portion 3314 may be a portion of the first flexible printed circuit board 331. The (2-2)^{th} flexible portion 3324 may be a portion of the second flexible printed circuit board 332.

According to an embodiment, the flexible circuit board 330 may include an extension 337. The extension 337 may connect the first flexible portion 335 and the second flexible portion 336. The extension 337 may include a flexible material or a rigid material. The extension 337 may be a soft body or a rigid body. The extension 337 may extend between the first flexible portion 335 and the second flexible portion 336. The extension 337 may include a first extension 3315 connecting the (1-1)^{th} flexible portion 3313 and the (2-1)^{th} flexible portion 3314. The extension 337 may include a second extension 3325 connecting the (1-2)^{th} flexible portion 3323 and the (2-2)^{th} flexible portion 3324. The first extension 3315 may be a portion of the first flexible printed circuit board 331. The second extension 3325 may be a portion of the second flexible printed circuit board 332.

According to an embodiment, the (1-1)^{th} rigid portion 3311, the (2-1)^{th} rigid portion 3312, the (1-1)^{th} flexible portion 3313, the (2-1)^{th} flexible portion 3314, and the first extension 3315 may be formed integrally. The first flexible circuit board 331 may include the (1-1)^{th} rigid portion 3311, the (2-1)^{th} rigid portion 3312, the (1-1)^{th} flexible portion 3313, the (2-1)^{th} flexible portion 3314, and the first extension 3315.

According to an embodiment, the (1-2)^{th} rigid portion 3321, the (2-2)^{th} rigid portion 3322, the (1-2)^{th} flexible portion 3323, the (2-2)^{th} flexible portion 3324, and the second extension 3325 may be formed integrally. The second flexible circuit board 332 may include the (1-2)^{th} rigid portion 3321, the (2-2)^{th} rigid portion 3322, the (1-2)^{th} flexible portion 3323, the (2-2)^{th} flexible portion 3324, and the second extension 3325.

According to an embodiment, in the first state in which the first housing 301 is drawn into the second housing 302 as illustrated in FIG. 7A, at least a portion of the flexible printed circuit board 330 may be bent. In the first state, the first flexible portion 335 and the second flexible portion 336 may be bent. In the first state, the first flexible portion 335 and the second flexible portion 336 may be formed to be convex in opposite directions. In the first state, the first rigid portion 333, the second rigid portion 334, and the extension 337 may be arranged in the first direction (e.g., the +Y direction). In the first state, the first rigid portion 333, the second rigid portion 334, and the extension 337 may be arranged substantially parallel to each other.

According to an embodiment, in the second state in which the first housing 301 is pulled out from the second housing 302 as illustrated in FIG. 7B, the flexible printed circuit board 330 may be unfolded in the direction in which the first housing 301 is moved. In the second state, the first flexible portion 335 and the second flexible portion 336 may be unfolded more than in the first state. In the second state, the first flexible portion 335 and the second flexible portion 336 may have an arch shape. In the second state, the extension 337 may be inclined with respect to the direction in which the first housing 301 is moved (e.g., the +Y direction).

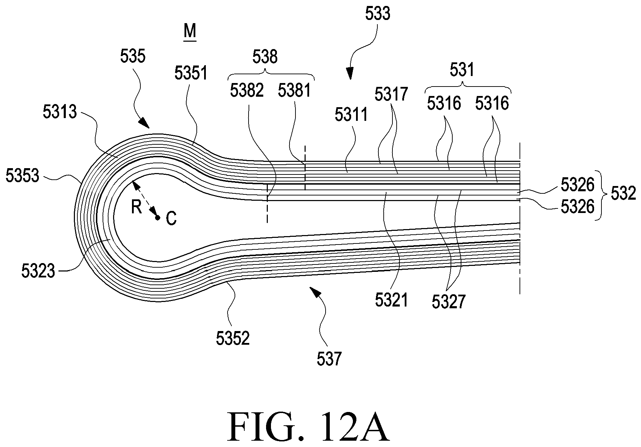

According to an embodiment, the (1-1)th rigid portion 3311 may be referred to as a "first rigid portion". The (1-2)^{th} rigid portion 3321 may be referred to as a "second rigid portion". The (2-1)^{th} rigid portion 3312 may be referred to as a "third rigid portion". The (2-2)^{th} rigid portion 3322 may be referred to as a "fourth rigid portion". The (1-1)^{th} flexible portion 3313 may be referred to as a "first flexible portion". The (1-2)^{th} flexible portion 3323 may be referred to as a "second flexible portion". The (2-1)^{th} flexible portion 3314 may be referred to as a "third flexible portion". The (2-2)^{th} flexible portion 3324 may be referred to as a "fourth flexible portion". The (1-1)^{th} boundary portion (e.g., the (1-1)^{th} boundary portion 5381 in FIG. 12A) may be referred to as a "first boundary portion". The (1-2)^{th} boundary portion (e.g., the (1-2)^{th} boundary portion 5382 in FIG. 12A) may be referred to as a "second boundary portion".

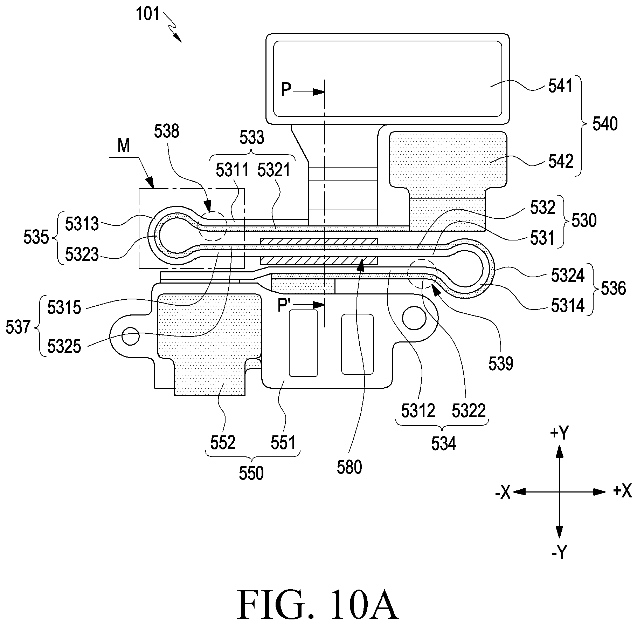

FIG. 9 is a view illustrating a portion of an electronic device according to an embodiment of the disclosure. FIG. 9 is a view illustrating a deforming process of the connectors 440 and 450 and the flexible circuit board 430 when changing from the state of FIG. 7C to the first state. The first state may be the state in which the first housing (e.g., the first housing 301 in FIGS. 7A and 7B) is drawn into the second housing (e.g., the second housing 302 in FIGS. 7A and 7B). The components to be described with reference to FIG. 9 may be partly or wholly the same as the components described with reference to FIGS. 1 to 8B. The components to be described with reference to FIG. 9 may be partly or wholly the same as the components to be described with reference to FIGS. 10A to 14C.

According to an embodiment, the electronic device 101 may include a flexible printed circuit board 430, a first connector 440, and a second connector 450. The description of components (e.g., the flexible printed circuit board 430, the first connector 440, and the second connector 450) described with reference to FIGS. 7A to 7C may be equally applicable to the flexible printed circuit board 430, the first connector 440, and the second connector 450. For example, the first connection portion 440a where the flexible printed circuit board 430 and the first connector 440 are connected may be located in the fourth direction (the +X direction) relative to the second connection portion 450a.

According to an embodiment, the flexible printed circuit board 430 may include a first flexible printed circuit board 431 and a second flexible printed circuit board 432. The description of the flexible printed circuit board 330 described with reference to FIGS. 8A and 8B may be equally applicable to the description of the flexible printed circuit board 430. For example, the flexible circuit board 430 may include a first rigid portion 433, a second rigid portion 434, a first flexible portion 435, a second flexible portion 436, and an extension 437. The description of the components described with reference to FIGS. 8A and 8B (e.g., the first rigid portion 333, the second rigid portion 334, the first flexible portion 335, the second flexible portion 336, and the extension 337 of FIGS. 8A and 8B) may be equally applicable to the description of the above-described components (e.g., the first rigid portion 433, the second rigid portion 434, the first flexible portion 435, the second flexible portion 436, and the extension 437). The first flexible circuit board 431 may connect the (1-1)^{th} connector 441 and the (2-1)^{th} connector 451. The second flexible circuit board 432 may connect the (1-2)^{th} connector 442 and the (2-2)^{th} connector 452. The (1-1)^{th} connector 441 may be located in the fourth direction (the +X direction) relative to the (1-2)^{th} connector 442. The (2-1)^{th} connector 451 may be located in the fourth direction (the +X direction) relative to the (2-2)^{th} connector 452.

According to an embodiment, when the first housing (e.g., the first housing 301 in FIGS. 7A and 7B) is changed from the second state in which the second housing (e.g., the second housing 302 in FIGS. 7A and 7B) is pulled out to the first state in which the first housing 301 is drawn into the second housing 302, the flexible printed circuit board 430 may be bent. In the first state, the first flexible portion 435 and the second flexible portion 436 may be formed to be convex in opposite directions. When changing from the second state to the first state, the first connector 440 may be moved a predetermined distance D. When changing from the second state to the first state, the width W between the first connector 440 and the second connector 450 may be maintained constant. In the case of the embodiment illustrated in FIG. 9, compared to the embodiment illustrated in FIG. 8B, the positions of the (1-1)^{th} connector 441 and the (1-2)^{th} connector 442 are switched to each other, and the positions of the (2-1)^{th} connector 451 and the (2-2)^{th} connector 452 are switched to each other, the vertical movement gap D may be formed large while the width W between the first connector 440 and the second connector 450 is maintained wide.

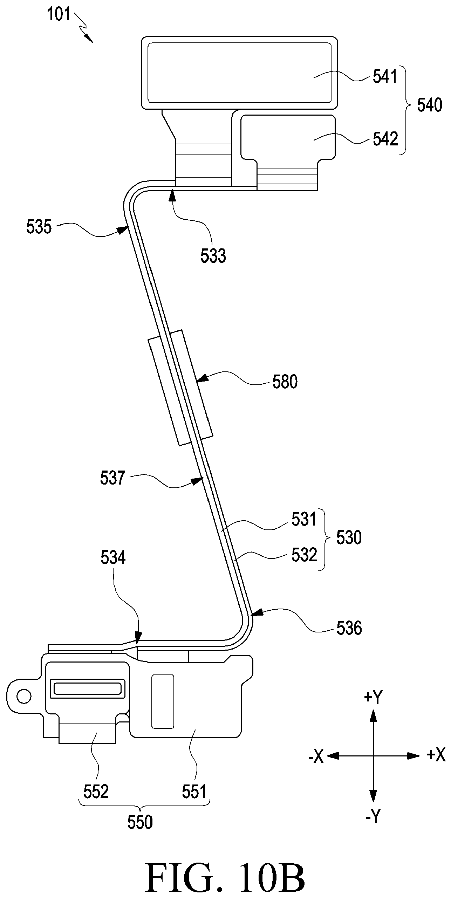

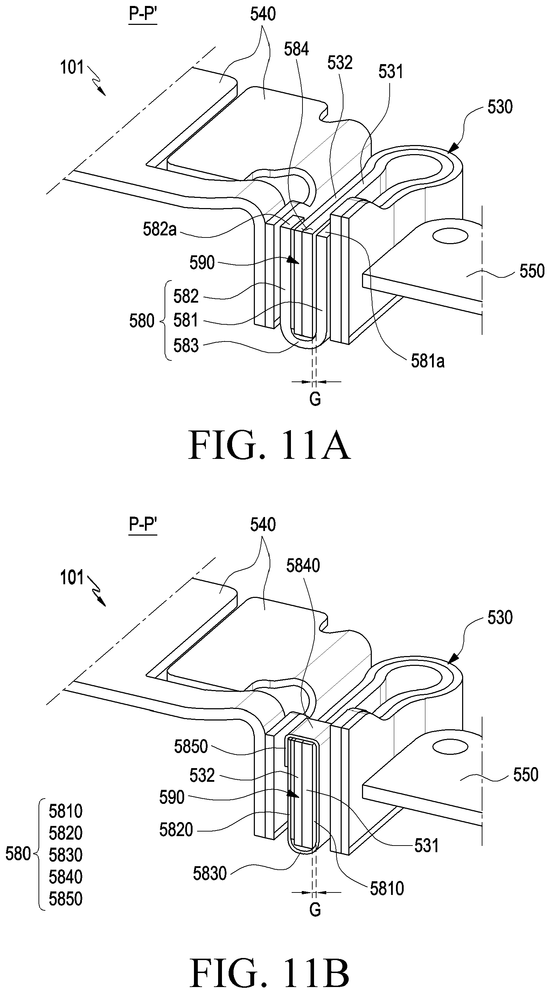

FIG. 10A is a view illustrating a portion of an electronic device according to an embodiment of the disclosure. FIG. 10A is a view illustrating connectors 540 and 550 and a flexible printed circuit board 530 according to an embodiment of the disclosure separated in the first state. FIG. 10B is a view illustrating a portion of an electronic device according to an embodiment of the disclosure. FIG. 10B is a view illustrating connectors 540 and 550 and a flexible printed circuit board 530 according to an embodiment of the present disclosure separated in the second state. The components to be described with reference to FIGS. 10A and 10B may be partially or entirely the same as the components described with reference to FIGS. 1 to 9. The components to be described with reference to FIGS. 10A and 10B may be partially or entirely the same as the components to be described with reference to FIGS. 11A to 14C.

According to an embodiment, the first connector 540 may include a (1-1)^{th} connector 541 and a (1-2)^{th} connector 542. The second connector 550 may include a (2-1)^{th} connector 551 and a (2-2)^{th} connector 552. The (1-1)^{th} connector 541 and the (2-1)^{th} connector 551 may be connected to each other via the first flexible circuit board 531. The (1-2)^{th} connector 542 and the (2-2)^{th} connector 552 may be connected to each other via the second flexible circuit board 532. The (1-1)^{th} connector 541 and the (1-2)^{th} connector 542 may be connected to a first circuit board (e.g., the first circuit board 310 in FIG. 6). The (2-1)^{th} connector 551 and the (2-2)^{th} connector 552 may be connected to a second circuit board (e.g., the second circuit board 320 in FIG. 6). The (1-1)^{th} connector 541 and the (2-1)^{th} connector 551 may correspond to a line that supplies power to the components of the electronic device 101, and may correspond to a line that implements an interface logic of the display assembly (e.g., the display assembly 230 in FIG. 4). The (1-2)^{th} connector 542 and the (2-2)^{th} connector 552 may correspond to an RF wire of an antenna (e.g., the first and second antennas 361 and 372 in FIGS. 6 and 7B). The (2-1)^{th} connector 551 may be connected to a battery (e.g., the battery 371 in FIG. 6) and may be connected to electronic components (e.g., a microphone, a wireless charger, and an NFC device) disposed inside a second housing (e.g., the second housing 302 in FIGS. 7A and 7B). The (2-2)^{th} connector 552 may be connected to a second antenna (e.g., the second antenna 372 in FIGS. 7A and 7B). The (1-1)^{th} connector 541 may be referred to as a "first power line". The (1-2)^{th} connector 542 may be referred to as a "first RF line". The (2-1)^{th} connector 551 may be referred to as a "second power line". The (2-2)^{th} connector 552 may be referred to as a "second RF line".

According to an embodiment, the flexible circuit board 530 may connect the first connector 540 and the second connector 550. The flexible circuit board 530 may include a first flexible circuit board 531 that connects the (1-1)^{th} connector 541 and the (2-1)^{th} connector 551. The flexible circuit board 530 may include a second flexible circuit board 532 that connects the (1-2)^{th} connector 542 and the (2-2)^{th} connector 552. The first flexible printed circuit board 531 and the second flexible printed circuit board 532 may extend parallel to each other. The first flexible circuit board 531 and the second flexible circuit board 532 may be coupled to each other or may be separated from each other.

According to an embodiment, the flexible printed circuit board 530 may include a plurality of layers. The flexible printed circuit board 530 may include a first layer 531 and a second layer 532. The first layer 531 may connect the (1-1)^{th} connector 541 and the (2-1)^{th} connector 551. The second layer 532 may connect the (1-2)^{th} connector 542 and the (2-2)^{th} connector 552. The first layer 531 and the second layer 532 may extend parallel to each other. The first layer 531 and the second layer 532 may be coupled to each other or may be separated from each other. The first layer 531 may be a first flexible printed circuit board. The second layer 532 may be a second flexible printed circuit board.

According to an embodiment, the flexible circuit board 530 may include a first rigid portion 533. The first rigid portion 533 may be connected to the first connector 540. The first rigid portion 533 includes a (1-1)^{th} rigid portion 5311 connected to the (1-1)^{th} connector 541 and a (1-2)^{th} rigid portion 5321 connected to the (1-2)^{th} connector 542. The (1-1)^{th} rigid portion 5311 may be a portion of the first flexible printed circuit board 531. The (1-2)^{th} rigid portion 5321 may be a portion of the second flexible circuit board 532.

According to an embodiment, the flexible circuit board 530 may include a second rigid portion 533. The second rigid portion 534 may be connected to the second connector 550. The second rigid portion 534 includes a (2-1)^{th} rigid portion 5312 connected to the (2-1)^{th} connector 551 and a (2-2)^{th} rigid portion 5322 connected to the (2-2)^{th} connector 552. The (2-1)^{th} rigid portion 5312 may be a portion of the first flexible printed circuit board 531. The (2-2)^{th} rigid portion 5322 may be a portion of the second flexible circuit board 532.

According to an embodiment, the flexible circuit board 530 may include a first flexible portion 535. The first flexible portion 535 may be connected to the first rigid portion 533. The first flexible portion 535 may include a (1-1)^{th} flexible portion 5313 connected to the (1-1)^{th} rigid portion 5311 and a (1-2)^{th} flexible portion 5323 connected to the (1-2)^{th} rigid portion 5321. The (1-1)^{th} flexible portion 5313 may be a portion of the first flexible printed circuit board 531. The (1-2)^{th} flexible portion 5323 may be a portion of the second flexible printed circuit board 532.

According to an embodiment, the flexible circuit board 530 may include a second flexible portion 536. The second flexible portion 536 may be connected to the second rigid portion 534. The second flexible portion 536 may include a (2-1)^{th} flexible portion 5314 connected to the (2-1)^{th} rigid portion 5312 and a (2-2)^{th} flexible portion 5324 connected to the (2-2)^{th} rigid portion 5322. The (2-1)^{th} flexible portion 5314 may be a portion of the first flexible printed circuit board 531. The (2-2)^{th} flexible portion 5324 may be a portion of the second flexible printed circuit board 532.

According to an embodiment, the flexible circuit board 530 may include an extension 537. The extension 537 may connect the first flexible portion 535 and the second flexible portion 536. The extension 537 may include a flexible material or a rigid material. The extension 537 may be a soft body or a rigid body. The extension 537 may extend between the first flexible portion 535 and the second flexible portion 536. The extension 537 may include a first extension 5315 connecting the (1-1)^{th} flexible portion 5313 and the (2-1)^{th} flexible portion 5314. The extension 537 may include a second extension 5325 connecting the (1-2)^{th} flexible portion 5323 and the (2-2)^{th} flexible portion 5324. The first extension 5315 may be a portion of the first flexible printed circuit board 531. The second extension 5325 may be a portion of the second flexible printed circuit board 532.

According to an embodiment, the (1-1)^{th} rigid portion 5311, the (2-1)^{th} rigid portion 5312, the (1-1)^{th} flexible portion 5313, the (2-1)^{th} flexible portion 5314, and the first extension 5315 may be formed integrally. The first flexible circuit board 531 may include the (1-1)^{th} rigid portion 5311, the (2-1)^{th} rigid portion 5312, the (1-1)^{th} flexible portion 5313, the (2-1)^{th} flexible portion 5314, and the first extension 5315.

According to an embodiment, the (1-2)^{th} rigid portion 5321, the (2-2)^{th} rigid portion 5322, the (1-2)^{th} flexible portion 5323, the (2-2)^{th} flexible portion 5324, and the second extension 5325 may be formed integrally. The second flexible circuit board 532 may include the (1-2)^{th} rigid portion 5321, the (2-2)^{th} rigid portion 5322, the (1-2)^{th} flexible portion 5323, the (2-2)^{th} flexible portion 5324, and the second extension 5325.

According to an embodiment, in the first state in which the first housing 301 is drawn into the second housing 302 as illustrated in FIG. 10A, at least a portion of the flexible printed circuit board 530 may be bent. In the first state, the first flexible portion 535 and the second flexible portion 536 may be bent. In the first state, the first flexible portion 535 and the second flexible portion 536 may be formed to be convex in opposite directions. In the first state, the first rigid portion 533, the second rigid portion 534, and the extension 537 may be arranged in the first direction (e.g., the +Y direction). In the first state, the first rigid portion 533, the second rigid portion 534, and the extension 537 may be arranged substantially parallel to each other.

According to an embodiment, in the second state in which the first housing 301 is pulled out from the second housing 302 as illustrated in FIG. 10B, the flexible printed circuit board 530 may be unfolded in the direction in which the first housing 301 is moved. In the second state, the first flexible portion 535 and the second flexible portion 536 may be unfolded more than in the first state. In the second state, the first flexible portion 535 and the second flexible portion 536 may have an arch shape. In the second state, the extension 537 may be inclined with respect to the direction in which the first housing 301 is moved (e.g., the +Y direction).

According to an embodiment, the flexible circuit board 530 may include a first boundary portion 538. The first boundary portion 538 may be formed between the first rigid portion 533 and the first flexible portion 535. The first boundary portion 538 may connect the first rigid portion 533 and the first flexible portion 535. The first boundary portion 538, the first rigid portion 533, and the first flexible portion 535 may be integrally formed.

According to an embodiment, the flexible circuit board 530 may include a second boundary portion 539. The second boundary portion 539 may be formed between the second rigid portion 534 and the second flexible portion 536. The second boundary portion 539 may connect the second rigid portion 534 and the second flexible portion 536. The second boundary portion 539, the second rigid portion 534, and the second flexible portion 536 may be integrally formed.

According to an embodiment, the electronic device 101 may include a body 580. The body 580 may be referred to as a "holder". The body 580 may be referred to as a "block". The body 580 may be referred to as a "support". The body 580 may be referred to as a "clamp". The body 580 may be referred to as a "guide rib". The body 580 may be arranged to surround at least a portion of the flexible printed circuit board 530. The body 580 may extend along the peripheral surface of the flexible printed circuit board 530. The body 580 may be arranged to surround at least a portion of the extension 537. The body 580 may extend along the peripheral surface of the extension 537. At least a portion of the body 580 may be coupled to the flexible printed circuit board 530. The body 580 may be coupled with either the first flexible printed circuit board 531 or the second flexible printed circuit board 532. The body 580 may be located between the first rigid portion 533 and the second rigid portion 534 in the first state. The body 580 may be moved together with the flexible printed circuit board 530. The body 580 may be arranged to surround the first flexible printed circuit board 531 and the second flexible printed circuit board 532, thereby preventing the phenomenon of gaping between the first flexible printed circuit board 531 and the second flexible printed circuit board 532. The body 580 is coupled to either the first flexible printed circuit board 531 or the second flexible printed circuit board 532, thereby allowing relative movement between the first flexible printed circuit board 531 and the second flexible printed circuit board 532 so that friction between the first flexible printed circuit board 531 and the second flexible printed circuit board 532 can be reduced.

FIG. 11A is a view illustrating a portion of an electronic device according to an embodiment of the disclosure. FIG. 11A is a cross-sectional perspective view taken along line reference line P-P' illustrated in FIG. 10A. FIG. 11B is a view illustrating a portion of an electronic device according to an embodiment of the disclosure. FIG. 11B is a cross-sectional perspective view taken along reference line P-P' of the structure of FIG. 10A in the state in which a body 5800 according to an embodiment of the disclosure is coupled. The components to be described with reference to FIGS. 11A and 11B may be partially or entirely the same as the components to be described with reference to FIGS. 1 to 10B. The components to be described with reference to FIGS. 11A and 11B may be partially or entirely the same as the components to be described with reference to FIGS. 12A to 14C.

According to an embodiment, the electronic device 101 may include a body 580 or 5800. The body 580 or 5800 may have the shape of the body 580 illustrated in FIG. 11A or the shape of the body 5800 illustrated in FIG. 11B. The body 580 or 5800 may be arranged to surround the flexible printed circuit board 530. The body 580 or 5800 may be coupled with either the first flexible printed circuit board 531 or the second flexible printed circuit board 532.

Referring to FIG. 11A, the body 580 may be arranged to surround the flexible printed circuit board 530. The body 580 may include a first portion 581. The first portion 581 may face the first flexible circuit board 531. The first portion 581 may be spaced apart from the first flexible circuit board 531. A gap G may be formed between the first portion 581 and the first flexible circuit board 531. The body 580 may include a second portion 582. The second portion 582 may face the second flexible circuit board 532. The second portion 582 may be coupled with the second flexible circuit board 532. The electronic device 101 may include a coupling member 590 disposed between the second portion 582 and the second flexible circuit board 532. The coupling member 590 may include an adhesive material. The body 580 according to an embodiment of the disclosure may have a first portion 581 coupled to the first flexible printed circuit board 531 and a second portion 582 spaced apart from the second flexible printed circuit board 532. The body 580 may include a first bending portion 583. The first bending portion 583 may connect the first portion 581 and the second portion 582. The first bending portion 583 may cover the first flexible printed circuit board 531 and the second flexible printed circuit board 532. The first portion 581 may include a first end 581a. The second portion 582 may include a second end 582a. The first end 581a and the second end 582a may be spaced apart from each other. The body 580 may include an opening 584 formed between the first end 581a and the second end 582a. One surface of the flexible printed circuit board 530 may be exposed to the outside of the body 580 through the opening 584.

Referring to FIG. 11B, the body 5800 may be arranged to surround the flexible printed circuit board 530. The body 5800 may include a first portion 5810. The first portion 5810 may face the first flexible circuit board 531. The first portion 5810 may be spaced apart from the first flexible circuit board 531. A gap G may be formed between the first portion 5810 and the first flexible circuit board 531. The body 5800 may include a second portion 5820. The second portion 5820 may face the second flexible circuit board 532. The second portion 5820 may be coupled with the second flexible circuit board 532. The electronic device 101 may include a coupling member 590 disposed between the second portion 5820 and the second flexible circuit board 532. The coupling member 590 may include an adhesive material. The body 5800 according to an embodiment of the disclosure may have a first portion 5810 coupled to the first flexible printed circuit board 531 and a second portion 5820 spaced apart from the second flexible printed circuit board 532. The body 5800 may include a first bending portion 5830. The first bending portion 5830 may connect the first portion 5810 and the second portion 5820. The first bending portion 5830 may cover the first flexible printed circuit board 531 and the second flexible printed circuit board 532. The body 5800 may include a second bending portion 5840. The second bending portion 5840 may connect the first portion 5810 and the second portion 5820. The second bending portion 5840 may cover the first flexible printed circuit board 531 and the second flexible printed circuit board 532. The first flexible printed circuit board 531 and the second flexible printed circuit board 532 may be located between the first bending portion 5830 and the second bending portion 5840. The body 5800 may include an edge 5850. The edge 5850 may be connected to the second bending portion 5840. The edge 5850 may cover at least a portion of the second portion 5820.

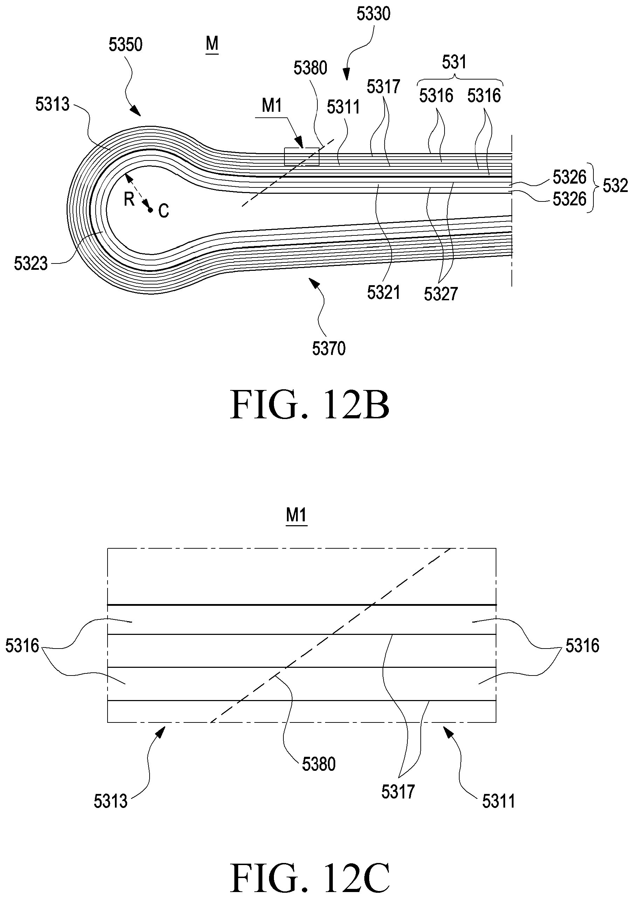

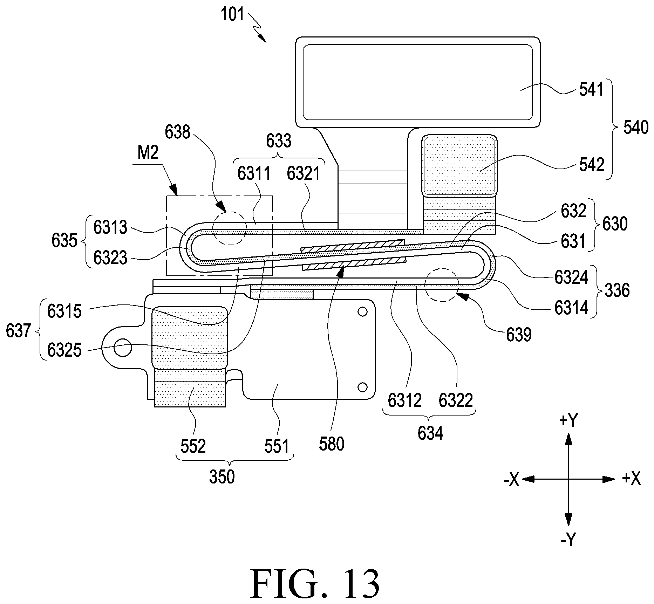

FIG. 12A is a view illustrating a portion of an electronic device according to an embodiment of the disclosure. FIG. 12A is a cross-sectional view of an area M illustrated in FIG. 10A according to an embodiment. FIG. 12B is a view illustrating a portion of an electronic device according to an embodiment of the disclosure. FIG. 12B is a cross-sectional view of the area M illustrated in FIG. 10A according to an embodiment. FIG. 12C is a view illustrating a portion of an electronic device according to an embodiment of the disclosure. FIG. 12C is an enlarged view of an M1 area illustrated in FIG. 12B. The components to be described with reference to FIGS. 12A to 12C may be partly or wholly the same as the components described with reference to FIGS. 1 to 11B. The components to be described with reference to FIGS. 12A to 12C may be partly or wholly the same as the components to be described with reference to FIGS. 13 to 14C.

According to an embodiment, the first flexible printed circuit board 531 may include a plurality of first layers 5316. The plurality of first layers 5316 may extend parallel to each other. The plurality of first layers 5316 may be stacked on each other. The flexible printed circuit board 530 may include a first adhesive member 5317 disposed between every two adjacent ones of the plurality of first layers 5316. The first adhesive member 5317 may bond two adjacent first layers 5316. The second flexible printed circuit board 532 may include a plurality of second layers 5326. The plurality of second layers 5326 may extend parallel to each other. The plurality of second layers 5326 may be stacked on each other. The flexible printed circuit board 530 may include a second adhesive member 5327 disposed between every two adjacent ones of the plurality of first layers 5326. The second adhesive member 5327 may bond two adjacent second layers 5326.

According to an embodiment, the rigid portions 533 and 534 may be portions where the adhesive member 5317 or 5327 is disposed between every two adjacent ones of the plurality of layers 5316 or 5326. The flexible portions 535 or 536 may be areas where the adhesive member 5317 or 5327 is not disposed between every two adjacent ones of the plurality of layers 5316 or 5326. However, the distinction between the rigid portions 533 and 534 and the flexible portions 535 and 536 is not limited to the above. For example, the rigid portions 533 and 534 may include a material with greater rigidity than the flexible portions 535 and 536. For example, the rigid portions 533 and 534 may be thicker than the flexible portions 535 and 536.

Referring to FIG. 12A, the flexible printed circuit board 530 may include a first flexible printed circuit board 531, a second flexible printed circuit board 532, a first rigid portion 533, a first flexible portion 535, and an extension 537. The first flexible portion 535 may be connected to the first rigid portion 533. The flexible printed circuit board 530 may include a first boundary portion 538. The first boundary portion 538 may be formed between the first flexible portion 535 and the first rigid portion 533. The first rigid portion 533 may include a (1-1)^{th} rigid portion 5311 and a (1-2)^{th} rigid portion 5321. The first flexible portion 535 may include a (1-1)^{th} flexible portion 5313 and a (1-2)^{th} flexible portion 5323. The (1-1)^{th} rigid portion 5311 may be connected to the (1-1)^{th} flexible portion 5313. The (1-2)^{th} rigid portion 5321 may be connected to the (1-2)^{th} flexible portion 5323. The first boundary portion 538 may include a (1-1)^{th} boundary portion 5381 formed between the (1-1)^{th} rigid portion 5311 and the (1-1)^{th} flexible portion 5313 and a (1-2)^{th} boundary portion 5382 formed between the (1-2)^{th} rigid portion 5321 and the (1-2)^{th} flexible portion 5323.

Referring to FIG. 12A, the (1-1)^{th} boundary portion 5381 and the (1-2)^{th} boundary portion 5382 may be dislocated from each other. The (1-1)^{th} boundary portion 5381 and the (1-2)^{th} boundary portion 5382 may be dislocated from each other with respect to the direction in which the first flexible printed circuit board 531 and the second flexible printed circuit board 532 are stacked. The (1-1)^{th} boundary portion 5381 may be located closer to the first rigid portion 533 than the (1-2)^{th} boundary portion 5382. The (1-1)^{th} boundary portion 5381 may be located closer to the first connector (e.g., the first connector 540 in FIG. 10A) than the (1-2)^{th} boundary portion 5382. The first adhesive member 5317 may extend to the (1-1)^{th} boundary portion 5381. The first adhesive member 5317 may be disposed inside the (1-1)^{th} rigid portion 5311. The first adhesive member 5317 may not be disposed in the (1-1)^{th} flexible portion 5313. The second adhesive member 5327 may extend to the (1-2)^{th} boundary portion 5382. The second adhesive member 5327 may be disposed inside the (1-2)^{th} rigid portion 5321. The second adhesive member 5327 may not be disposed in the (1-2)^{th} flexible portion 5323. The description of the first boundary portion 538 described above may be equally applicable to the second boundary portion (e.g., the second boundary portion 539 in FIG. 10A). For example, the second boundary portion 539 may include a (2-1)^{th} boundary portion formed between the (2-1)^{th} rigid portion 5312 and the (2-1)^{th} flexible portion 5314, and a (2-2)^{th} boundary portion formed between the (2-2)^{th} rigid portion 5322 and the (2-2)^{th} flexible portion 5324, and the (2-1)^{th} boundary portion and the (2-2)^{th} boundary portion may be dislocated from each other. The (2-1)^{th} boundary portion may be located farther from the second connector (e.g., the second connector 550 in FIG. 10A) than the (2-2)^{th} boundary portion.

Referring to FIG. 12A, the first flexible portion 535 may be formed to be convex toward the outside of the flexible printed circuit board 530. The first flexible portion 535 may have an arch shape with a radius R with respect to an imaginary center C. The first flexible portion 535 may include a first inflection portion 5351 and a second inflection portion 5352. The first inflection portion 5351 and the second inflection portion 5352 may be formed by being recessed in the outer surface of the first flexible circuit board 531. The first flexible portion 535 may include a round portion 5353. The round portion 5353 may connect the first inflection portion 5351 and the second inflection portion 5352.

Referring to FIGS. 12B and 12C, the flexible printed circuit board 530 may include a first flexible printed circuit board 531, a second flexible printed circuit board 532, a first rigid portion 5330, a first flexible portion 5350, and an extension 5370. The first flexible portion 5350 may be connected to the first rigid portion 5330. The flexible printed circuit board 530 may include a first boundary portion 5380. The first boundary portion 5380 may be formed between the first flexible portion 5350 and the first rigid portion 5330. The first rigid portion 5330 may include a (1-1)^{th} rigid portion 5311 and a (1-2)^{th} rigid portion 5321. The first flexible portion 5350 may include a (1-1)^{th} flexible portion 5313 and a (1-2)^{th} flexible portion 5323. The (1-1)^{th} rigid portion 5311 may be connected to the (1-1)^{th} flexible portion 5313. The (1-2)^{th} rigid portion 5321 may be connected to the (1-2)^{th} flexible portion 5323.

Referring to FIGS. 12B and 12C, the first boundary portion 5380 may extend obliquely with respect to the thickness direction of the flexible printed circuit board 530. The first boundary portion 5380 may extend obliquely with respect to the direction in which the first flexible printed circuit board 531 and the second flexible printed circuit board 532 are stacked. The first boundary portion 5380 may be inclined in a direction away from the first connector (e.g., the first connector 540 in FIG. 10A) as it approaches from the first flexible printed circuit board 531 to the second flexible printed circuit board 532. The first adhesive member 5317 may extend to the first boundary portion 5380. The first adhesive member 5317 may be disposed inside the (1-1)^{th} rigid portion 5311. The first adhesive member 5317 may not be disposed in the (1-1)^{th} flexible portion 5313. The second adhesive member 5327 may extend to the first boundary portion 5380. The second adhesive member 5327 may be disposed inside the (1-2)^{th} rigid portion 5321. The second adhesive member 5327 may not be disposed in the (1-2)^{th} flexible portion 5323. The description of the first boundary portion 5380 described above may be equally applicable to the second boundary portion (e.g., the second boundary portion 539 in FIG. 10A). For example, the second boundary portion 539 may extend obliquely with respect to the thickness direction of the flexible printed circuit board 530. The second boundary portion 539 may extend obliquely with respect to the direction in which the first flexible printed circuit board 531 and the second flexible printed circuit board 532 are stacked. The second boundary portion 539 may be inclined in a direction away from the second connector (e.g., the second connector 550 in FIG. 10A) as it approaches from the second flexible printed circuit board 532 to the first flexible printed circuit board 531.

Referring to FIGS. 12B and 12C, the first flexible portion 5350 may be formed to be convex toward the outside of the flexible printed circuit board 530. The first flexible portion 5350 may have an arch shape with a radius R with respect to an imaginary center C. The description of the first flexible portion 535 described with reference to FIG. 12A may be equally applicable to the shape of the first flexible portion 5350.

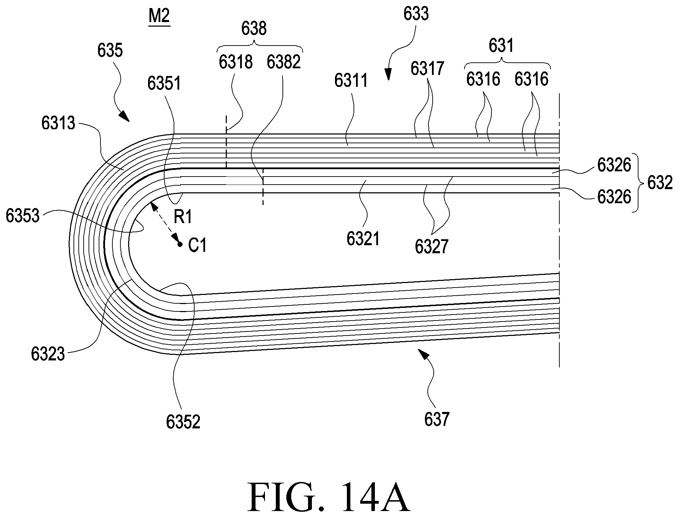

FIG. 13 is a view illustrating a portion of an electronic device according to an embodiment of the disclosure. FIG. 13 is a view illustrating connectors 540 and 550 and a flexible printed circuit board 630 according to an embodiment of the disclosure separated in the first state. The components to be described with reference to FIG. 13 may be partly or wholly the same as the components described with reference to FIGS. 1 to 12B. The components to be described with reference to FIG. 13 may be partly or wholly the same as the components to be described with reference to FIGS. 14A to 14C.

According to an embodiment, an electronic device 101 may include a first connector 540 and a second connector 550. The description of the first and second connectors 540 and 550 described with reference to FIG. 10A may be equally applicable to the first and second connectors 540 and 550.

According to an embodiment, the flexible circuit board 630 may connect the first connector 540 and the second connector 550. The flexible circuit board 630 may include a first flexible circuit board 631 that connects the (1-1)^{th} connector 541 and the (2-1)^{th} connector 551. The flexible circuit board 630 may include a second flexible circuit board 632 that connects the (1-2)^{th} connector 542 and the (2-2)^{th} connector 552. The first flexible printed circuit board 631 and the second flexible printed circuit board 632 may extend parallel to each other. The first flexible circuit board 631 and the second flexible circuit board 632 may be coupled to each other or may be separated from each other.

According to an embodiment, the flexible printed circuit board 630 may include a plurality of layers. The flexible printed circuit board 630 may include a first layer 631 and a second layer 632. The first layer 631 may connect the (1-1)^{th} connector 541 and the (2-1)^{th} connector 551. The second layer 632 may connect the (1-2)^{th} connector 542 and the (2-2)^{th} connector 552. The first layer 631 and the second layer 632 may extend parallel to each other. The first layer 631 and the second layer 632 may be coupled to each other or may be separated from each other. The first layer 631 may be a first flexible printed circuit board. The second layer 632 may be a second flexible printed circuit board.

According to an embodiment, the flexible circuit board 630 may include a first rigid portion 633. The first rigid portion 633 may be connected to the first connector 540. The first rigid portion 633 includes a (1-1)^{th} rigid portion 6311 connected to the (1-1)^{th} connector 541 and a (1-2)^{th} rigid portion 6321 connected to the (1-2)^{th} connector 542. The (1-1)^{th} rigid portion 6311 may be a portion of the first flexible printed circuit board 631. The (1-2)^{th} rigid portion 6321 may be a portion of the second flexible circuit board 632.

According to an embodiment, the flexible circuit board 630 may include a second rigid portion 634. The second rigid portion 634 may be connected to the second connector 550. The second rigid portion 634 includes a (2-1)^{th} rigid portion 6312 connected to the (2-1)^{th} connector 551 and a (2-2)^{th} rigid portion 6322 connected to the (2-2)^{th} connector 552. The (2-1)^{th} rigid portion 6312 may be a portion of the first flexible printed circuit board 631. The (2-2)^{th} rigid portion 6322 may be a portion of the second flexible circuit board 632.

According to an embodiment, the flexible circuit board 630 may include a first flexible portion 635. The first flexible portion 635 may be connected to the first rigid portion 633. The first flexible portion 635 may include a (1-1)^{th} flexible portion 6313 connected to the (1-1)^{th} rigid portion 6311 and a (1-2)^{th} flexible portion 6323 connected to the (1-2)^{th} rigid portion 6321. The (1-1)^{th} flexible portion 6313 may be a portion of the first flexible printed circuit board 631. The (1-2)^{th} flexible portion 6323 may be a portion of the second flexible printed circuit board 632.

According to an embodiment, the flexible circuit board 630 may include a second flexible portion 636. The second flexible portion 636 may be connected to the second rigid portion 634. The second flexible portion 636 may include a (2-1)^{th} flexible portion 6314 connected to the (2-1)^{th} rigid portion 6312 and a (2-2)^{th} flexible portion 6324 connected to the (2-2)^{th} rigid portion 6322. The (2-1)^{th} flexible portion 6314 may be a portion of the first flexible printed circuit board 631. The (2-2)^{th} flexible portion 6324 may be a portion of the second flexible printed circuit board 632.

According to an embodiment, the flexible circuit board 630 may include an extension 637. The extension 637 may connect the first flexible portion 635 and the second flexible portion 636. The extension 637 may include a flexible material or a rigid material. The extension 637 may be a soft body or a rigid body. The extension 637 may extend between the first flexible portion 635 and the second flexible portion 636. The extension 637 may include a first extension 6315 connecting the (1-1)^{th} flexible portion 6313 and the (2-1)^{th} flexible portion 6314. The extension 637 may include a second extension 6325 connecting the (1-2)^{th} flexible portion 6323 and the (2-2)^{th} flexible portion 6324. The first extension 6315 may be a portion of the first flexible printed circuit board 631. The second extension 6325 may be a portion of the second flexible printed circuit board 632.

According to an embodiment, the (1-1)^{th} rigid portion 6311, the (2-1)^{th} rigid portion 6312, the (1-1)^{th} flexible portion 6313, the (2-1)^{th} flexible portion 6314, and the first extension 6315 may be formed integrally. The first flexible circuit board 631 may include the (1-1)^{th} rigid portion 6311, the (2-1)^{th} rigid portion 6312, the (1-1)^{th} flexible portion 6313, the (2-1)^{th} flexible portion 6314, and the first extension 6315.

According to an embodiment, the (1-2)^{th} rigid portion 6321, the (2-2)^{th} rigid portion 6322, the (1-2)^{th} flexible portion 6323, the (2-2)^{th} flexible portion 6324, and the second extension 6325 may be formed integrally. The second flexible circuit board 632 may include the (1-2)^{th} rigid portion 6321, the (2-2)^{th} rigid portion 6322, the (1-2)^{th} flexible portion 6323, the (2-2)^{th} flexible portion 6324, and the second extension 6325.

According to an embodiment, in the first state in which the first housing 301 is drawn into the second housing 302 as illustrated in FIG. 14A, at least a portion of the flexible printed circuit board 630 may be bent. In the first state, the first flexible portion 635 and the second flexible portion 636 may be bent. In the first state, the first flexible portion 635 and the second flexible portion 636 may be formed to be convex in opposite directions. In the first state, the first rigid portion 633, the second rigid portion 634, and the extension 637 may be arranged in the first direction (e.g., the +Y direction). In the first state, the first rigid portion 633, the second rigid portion 634, and the extension 637 may be arranged substantially parallel to each other.

According to an embodiment, the flexible circuit board 630 may include a first extension 638. The first boundary portion 638 may be formed between the first rigid portion 633 and the first flexible portion 635. The first boundary portion 638 may connect the first rigid portion 633 and the first flexible portion 635. The first boundary portion 638, the first rigid portion 633, and the first flexible portion 635 may be integrally formed.

According to an embodiment, the flexible circuit board 630 may include a second extension 639. The second boundary portion 639 may be formed between the second rigid portion 634 and the second flexible portion 636. The second boundary portion 639 may connect the second rigid portion 634 and the second flexible portion 636. The second boundary portion 639, the second rigid portion 634, and the second flexible portion 636 may be integrally formed.

According to an embodiment, the electronic device 101 may include a body 580. The body 580 may be referred to as a "holder". The body 580 may be referred to as a "block". The body 580 may be referred to as a "support". The body 580 may be referred to as a "clamp". The body 580 may be arranged to surround at least a portion of the flexible printed circuit board 630. The body 580 may extend along the peripheral surface of the flexible printed circuit board 630. The body 580 may be arranged to surround the extension 637. The body 580 may extend along the peripheral surface of the extension 637. At least a portion of the body 580 may be coupled to the flexible printed circuit board 630. The body 580 may be coupled with either the first flexible printed circuit board 631 or the second flexible printed circuit board 632. The body 580 may be located between the first rigid portion 633 and the second rigid portion 634 in the first state. The body 580 may be moved together with the flexible printed circuit board 630. The body 580 may be arranged to surround the first flexible printed circuit board 631 and the second flexible printed circuit board 632, thereby preventing the phenomenon of gaping between the first flexible printed circuit board 631 and the second flexible printed circuit board 632. The body 580 is coupled to either the first flexible printed circuit board 631 or the second flexible printed circuit board 632, thereby allowing relative movement between the first flexible printed circuit board 631 and the second flexible printed circuit board 632 so that friction between the first flexible printed circuit board 631 and the second flexible printed circuit board 632 can be reduced.

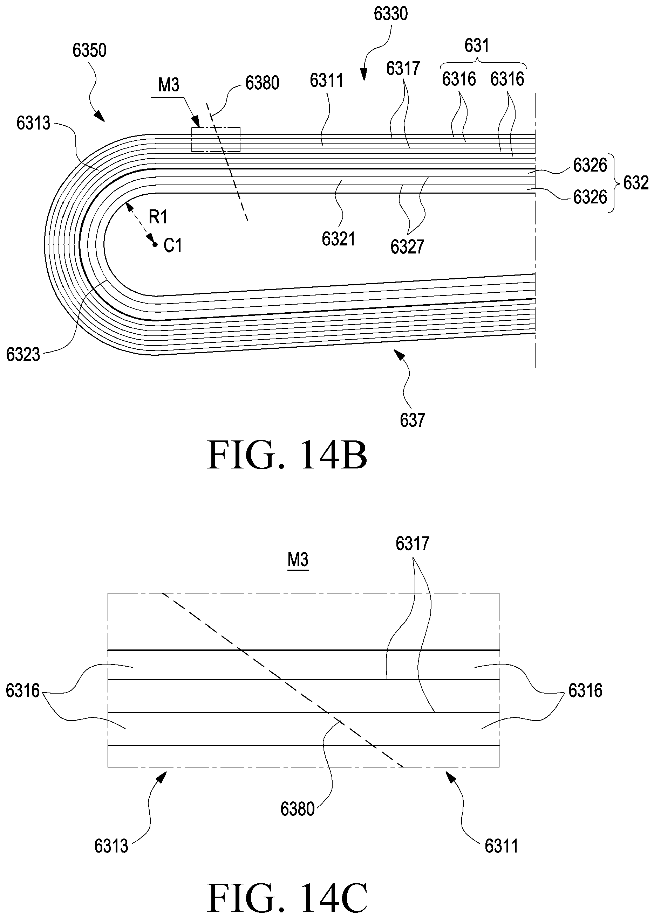

FIG. 14A is a view illustrating a portion of an electronic device according to an embodiment of the disclosure. FIG. 14A is a cross-sectional view of the area M2 illustrated in FIG. 13 according to an embodiment. FIG. 14B is a view illustrating a portion of an electronic device according to an embodiment of the disclosure. FIG. 14B is a view illustrating a cross-sectional view of the area M2 illustrated in FIG. 13 according to an embodiment. FIG. 14C is a view illustrating a portion of an electronic device according to an embodiment of the disclosure. FIG. 14C is an enlarged view of a portion (e.g., the area M3) of FIG. 14B. The components to be described with reference to FIGS. 14A to 14C may be partly or wholly the same as the components described with reference to FIGS. 1 to 13.

According to an embodiment, the first flexible printed circuit board 631 may include a plurality of first layers 6316. The plurality of first layers 6316 may extend parallel to each other. The plurality of first layers 6316 may be stacked on each other. The flexible printed circuit board 630 may include a first adhesive member 6317 disposed between every two adjacent ones of the plurality of first layers 6316. The first adhesive member 6317 may bond two adjacent first layers 6316. The second flexible printed circuit board 632 may include a plurality of second layers 6326. The plurality of second layers 6326 may extend parallel to each other. The plurality of second layers 6326 may be stacked on each other. The flexible printed circuit board 630 may include a second adhesive member 6327 disposed between every two adjacent ones of the plurality of first layers 6326. The second adhesive member 6327 may bond two adjacent second layers 6326.

According to an embodiment, the rigid portions 633 and 634 may be portions where the adhesive member 6317 or 6327 is disposed between every two adjacent ones of the plurality of layers 6316 or 6326. The flexible portions 635 or 636 may be areas where the adhesive member 6317 or 6327 is not disposed between every two adjacent ones of the plurality of layers 6316 or 6326. However, the distinction between the rigid portions 633 and 634 and the flexible portions 635 and 636 is not limited to the above. For example, the rigid portions 633 and 634 may include a material with greater rigidity than the flexible portions 635 and 636. For example, the rigid portions 633 and 634 may be thicker than the flexible portions 635 and 636.

Referring to FIG. 14A, the flexible printed circuit board 630 may include a first flexible printed circuit board 631, a second flexible printed circuit board 632, a first rigid portion 633, a first flexible portion 635, and an extension 637. The first flexible portion 635 may be connected to the first rigid portion 633. The flexible printed circuit board 630 may include a first boundary portion 638. The first boundary portion 638 may be formed between the first flexible portion 635 and the first rigid portion 633. The first rigid portion 633 may include a (1-1)^{th} rigid portion 6311 and a (1-2)^{th} rigid portion 6321. The first flexible portion 635 may include a (1-1)^{th} flexible portion 6313 and a (1-2)^{th} flexible portion 6323. The (1-1)^{th} rigid portion 6311 may be connected to the (1-1)^{th} flexible portion 6313. The (1-2)^{th} rigid portion 6321 may be connected to the (1-2)^{th} flexible portion 6323. The first boundary portion 638 may include a (1-1)^{th} boundary portion 6381 formed between the (1-1)^{th} rigid portion 6311 and the (1-1)^{th} flexible portion 6313 and a (1-2)^{th} boundary portion 6382 formed between the (1-2)^{th} rigid portion 6321 and the (1-2)^{th} flexible portion 6323.

Referring to FIG. 14A, the (1-1)^{th} boundary portion 6381 and the (1-2)^{th} boundary portion 6382 may be dislocated from each other. The (1-1)^{th} boundary portion 6381 and the (1-2)^{th} boundary portion 6382 may be dislocated from each other with respect to the direction in which the first flexible printed circuit board 631 and the second flexible printed circuit board 632 are stacked. The (1-1)^{th} boundary portion 6381 may be located farther from the first rigid portion 633 than the (1-2)^{th} boundary portion 6382. The (1-1)^{th} boundary portion 6381 may be located farther from the first connector (e.g., the first connector 540 in FIG. 13) than the (1-2)^{th} boundary portion 6382. The first adhesive member 6317 may extend to the (1-1)^{th} boundary portion 6381. The first adhesive member 6317 may be disposed inside the (1-1)^{th} rigid portion 6311. The first adhesive member 6317 may not be disposed in the (1-1)^{th} flexible portion 6313. The second adhesive member 6327 may extend to the (1-2)^{th} boundary portion 6382. The second adhesive member 6327 may be disposed inside the (1-2)^{th} rigid portion 6321. The second adhesive member 6327 may not be disposed in the (1-2)^{th} flexible portion 6323. The description of the first boundary portion 638 described above may be equally applicable to the second boundary portion (e.g., the second boundary portion 639 in FIG. 13). For example, the second boundary portion 639 may include a (2-1)^{th} boundary portion formed between the (2-1)^{th} rigid portion 6312 and the (2-1)^{th} flexible portion 6314, and a (2-2)^{th} boundary portion formed between the (2-2)^{th} rigid portion 6322 and the (2-2)^{th} flexible portion 6324, and the (2-1)^{th} boundary portion and the (2-2)^{th} boundary portion may be dislocated from each other. The (2-1)^{th} boundary portion may be located closer to the second connector (e.g., the second connector 550 in FIG. 13) than the (2-2)^{th} boundary portion.

Referring to FIG. 14A, the first flexible portion 635 may have an arch shape with a radius R1 with respect to an imaginary center C1. The first flexible portion 635 may include a first inflection portion 6351 and a second inflection portion 6352. The second inflection portion 6351 and the second inflection portion 6352 may be formed by being recessed in the outer surface of the first flexible circuit board 632. The first inflection portion 6351 and the second inflection portion 6352 may be formed on the surface of the second flexible printed circuit board 632 facing the center C1. The first flexible portion 635 may include a round portion 6353. The round portion 6353 may connect the first inflection portion 6351 and the second inflection portion 6352.

Referring to FIG. 14B, the flexible printed circuit board 630 may include a first flexible printed circuit board 631, a second flexible printed circuit board 632, a first rigid portion 6330, a first flexible portion 6350, and an extension 6370. The first flexible portion 6350 may be connected to the first rigid portion 6330. The flexible printed circuit board 630 may include a first boundary portion 6380. The first boundary portion 6380 may be formed between the first flexible portion 6350 and the first rigid portion 6330. The first rigid portion 6330 may include a (1-1)^{th} rigid portion 6311 and a (1-2)^{th} rigid portion 6321. The first flexible portion 6350 may include a (1-1)^{th} flexible portion 6313 and a (1-2)^{th} flexible portion 6323. The (1-1)^{th} rigid portion 6311 may be connected to the (1-1)^{th} flexible portion 6313. The (1-2)^{th} rigid portion 6321 may be connected to the (1-2)^{th} flexible portion 6323.

Referring to FIG. 14B, the first boundary portion 6380 may extend obliquely with respect to the thickness direction of the flexible printed circuit board 630. The first boundary portion 6380 may extend obliquely with respect to the direction in which the first flexible printed circuit board 631 and the second flexible printed circuit board 632 are stacked. The first boundary portion 6380 may be inclined in a direction closer to the first connector (e.g., the first connector 540 in FIG. 13) as it approaches from the first flexible printed circuit board 631 to the second flexible printed circuit board 632. The first adhesive member 6317 may extend to the first boundary portion 6380. The first adhesive member 6317 may be disposed inside the (1-1)^{th} rigid portion 6311. The first adhesive member 6317 may not be disposed in the (1-1)^{th} flexible portion 6313. The second adhesive member 6327 may extend to the first boundary portion 6380. The second adhesive member 6327 may be disposed inside the (1-2)^{th} rigid portion 6321. The second adhesive member 6327 may not be disposed in the (1-2)^{th} flexible portion 6323. The description of the first boundary portion 6380 described above may be equally applicable to the second boundary portion (e.g., the second boundary portion 639 in FIG. 13). For example, the second boundary portion 639 may extend obliquely with respect to the thickness direction of the flexible printed circuit board 630. The second boundary portion 639 may extend obliquely with respect to the direction in which the first flexible printed circuit board 631 and the second flexible printed circuit board 632 are stacked. The second boundary portion 639 may be inclined in a direction closer to the second connector (e.g., the second connector 550 in FIG. 13) as it approaches from the second flexible printed circuit board 632 to the first flexible printed circuit board 631.

Referring to FIG. 14B, the first flexible portion 6350 may have an arch shape with a radius R1 with respect to an imaginary center C1. The description of the first flexible portion 635 described with reference to FIG. 14A may be equally applicable to the shape of the first flexible portion 6350.

An electronic device includes a housing and a display disposed in the housing. An electronic device in which a display is movably disposed in a housing includes a circuit board that moves together with the display. The electronic device may include a flexible circuit board that connects the moving circuit board and electronic components inside the housing, and the flexible circuit board is deformed in response to the movement of the circuit board. The flexible printed circuit board may include a flexible portion, and the flexible portion may be a deformable portion of the flexible printed circuit board.

The problems to be solved by this disclosure may be to facilitate the deformation of the flexible circuit board.

The problem to be solved in the disclosure may be to increase the deformation range of the flexible circuit board.

The problems to be solved in the disclosure are not limited to the above-mentioned problems and may expand in various ways without departing from the scope of the appended claims.

In an electronic device according to various embodiments of the disclosure, the flexible printed circuit board may be easily deformed by including the first flexible portion and the second flexible portion.

In an electronic device according to various embodiments of the disclosure, the deformable range of the flexible printed circuit board may be increased by including the first flexible portion and the second flexible portion.

The effects that are capable of being obtained by the disclosure are not limited to those described above, and other effects not described above may be clearly understood by a person ordinarily skilled in the art to which the disclosure belongs based on the following description.

An electronic device (101 in FIGS. 1 to 14C) according to an embodiment of the disclosure may include a first housing (301 in FIGS. 1 to 14C).

The electronic device (e.g., 101 in FIGS. 1 to 14C) according to an embodiment of the disclosure may include a second housing (e.g., 302 in FIGS. 1 to 14C) to which the first housing (e.g., 301 in FIGS. 1 to 14C) is movably coupled.

The electronic device (e.g., 101 in FIGS. 1 to 14C) according to an embodiment of the disclosure may include a first circuit board (e.g., 310 in FIGS. 1 to 14C) which is disposed inside the first housing (e.g., 301 in FIGS. 1 to 14C) to be movable relative to the second housing (e.g., 302 in FIGS. 1 to 14C).

The electronic device (e.g., 101 in FIGS. 1 to 14C) according to an embodiment of the disclosure may include a second circuit board (e.g., 320 in FIGS. 1 to 14C) disposed inside the second housing (e.g., 302 in FIGS. 1 to 14C).

The electronic device (e.g., 101 in FIGS. 1 to 14C) according to an embodiment of the disclosure may include a first flexible circuit board (e.g., 331, 531, or 631 in FIGS. 1 to 14C) electrically connecting the first circuit board (e.g., 310 in FIGS. 1 to 14C) and the second circuit board (e.g., 320 in FIGS. 1 to 14C), at least a portion of the first flexible circuit board (e.g., 331, 531, or 631 in FIGS. 1 to 14C) being configured to be deformable in response to the movement of the first circuit board (e.g., 310 in FIGS. 1 to 14C), and the first flexible circuit board (e.g., 331, 531, or 631 in FIGS. 1 to 14C) including a first flexible portion (e.g., 3313, 5313, or 6313 in FIGS. 1 to 14C) and a first rigid portion (e.g., 3311, 5311, or 6311 in FIGS. 1 to 14C) formed between the first circuit board (e.g., 310 in FIGS. 1 to 14C) and the first flexible portion (e.g., 3313, 5313, or 6313 in FIGS. 1 to 14C).

The electronic device (e.g., 101 in FIGS. 1 to 14C) according to an embodiment of the disclosure may include a second flexible circuit board (e.g., 332, 532, or 632 in FIGS. 1 to 14C) electrically connecting the first circuit board (e.g., 310 in FIGS. 1 to 14C) and the second circuit board (e.g., 320 in FIGS. 1 to 14C), at least a portion of the second flexible circuit board (e.g., 332, 532, or 632 in FIGS. 1 to 14C) being coupled to the first flexible circuit board (e.g., 331, 531, or 631 in FIGS. 1 to 14C) and being configured to be deformed in response to the deformation of at least a portion of the first flexible circuit board (e.g., 331 in FIGS. 1 to 14C), and the second flexible circuit board (e.g., 332, 532, or 632 in FIGS. 1 to 14C) including a second flexible portion (e.g., 3323, 5323, or 6323 in FIGS. 1 to 14C) and a second rigid portion (e.g., 3321, 5321, or 6321 in FIGS. 1 to 14C) formed between the first circuit board (e.g., 310 in FIGS. 1 to 14C) and the second flexible portion (e.g., 3323, 5323, or 6323 in FIGS. 1 to 14C).

According to an embodiment of the disclosure, a first boundary portion (e.g., 5381 or 6381 in FIGS. 1 to 14C) between the first flexible portion (e.g., 3313, 5313, or 6313 in FIGS. 1 to 14C) and the first rigid portion (e.g., 3311, 5311, or 6311 in FIGS. 1 to 14C) of the first flexible circuit board (e.g., 331, 531, or 631 in FIGS. 1 to 14C) may be dislocated from a second boundary portion (e.g., 5382 or 6382 in FIGS. 1 to 14C) between the second flexible portion (e.g., 3323, 5323, or 6323 in FIGS. 1 to 14C) and the second rigid portion (e.g., 3321, 5321, or 6321 in FIGS. 1 to 14C) of the second flexible circuit board (e.g., 332, 532, or 632 in FIGS. 1 to 14C).

According to an embodiment of the disclosure, the first boundary portion (e.g., 5381 in FIGS. 1 to 14C) and the second boundary portion (e.g., 5382 in FIGS. 1 to 14C) may be dislocated from each other in a direction intersecting with an extended direction of the first flexible circuit board (e.g., 531 in FIGS. 1 to 14C) and the second flexible circuit board (e.g., 532 in FIGS. 1 to 14C).

According to an embodiment of the disclosure, the first rigid portion (e.g., 5311 in FIGS. 1 to 14C) may include a plurality of first layers (e.g., 5316 in FIGS. 1 to 14C) stacked with each other.

According to an embodiment of the disclosure, the first rigid portion (e.g., 5311 in FIGS. 1 to 14C) may include a first adhesive member (e.g., 5317 in FIGS. 1 to 14C) disposed between the plurality of first layers (e.g., 5316 in FIGS. 1 to 14C) and extending to the first boundary portion (e.g., 5381 in FIGS. 1 to 14C). There may be no first adhesive member after the first boundary portion between the plurality of first layers. In other words, there may be no first adhesive layer in the first flexible portion. With no first adhesive layer in the first flexible portion, the first flexible portion can move more freely.

According to an embodiment of the disclosure, the second rigid portion (e.g., 5321 in FIGS. 1 to 14C) may include a plurality of second layers (e.g., 5326 in FIGS. 1 to 14C) stacked with each other.

According to an embodiment of the disclosure, the second rigid portion (e.g., 5321 in FIGS. 1 to 14C) may include a second adhesive member (e.g., 5327 in FIGS. 1 to 14C) disposed between the plurality of second layers (e.g., 5326 in FIGS. 1 to 14C) and extending to the second boundary portion (e.g., 5382 in FIGS. 1 to 14C). There may be no second adhesive member after the second boundary portion between the plurality of second layers. In other words, there may be no second adhesive layer in the second flexible portion. With no second adhesive layer in the second flexible portion, the second flexible portion can move more freely.

According to an embodiment of the disclosure, the first boundary portion (e.g., 5381 in FIGS. 1 to 14C) may be inclined with respect to a direction in which the first flexible circuit board (e.g., 531 in FIGS. 1 to 14C) is extended, and the second boundary portion (e.g., 5382 in FIGS. 1 to 14C) is inclined with respect to a direction in which the second flexible circuit board (e.g., 532 in FIGS. 1 to 14C) is extended.

According to an embodiment of the disclosure, the first boundary portion (e.g., 5381 in FIGS. 1 to 14C) may be positioned closer to the first circuit board (e.g., 310 in FIGS. 1 to 14C) than the second boundary portion (e.g., 5382 in FIGS. 1 to 14C).

According to an embodiment of the disclosure, the first boundary portion (e.g., 6381 in FIGS. 1 to 14C) may be positioned farther from the first circuit board (e.g., 310 in FIGS. 1 to 14C) than the second boundary portion (e.g., 6382 in FIGS. 1 to 14C).

The first boundary portion being positioned closer or farther to the first circuit board than the second boundary portion influences the shape of the first and second flexible portions in the first state (e.g. shape of the first flexible portion 535 and the second flexible portion 536 in Fig. 10A compared to the shape of the first flexible portion 635 and the second flexible portion 636 in Fig. 13).

According to an embodiment of the disclosure, the first flexible circuit board (e.g., 531 in FIGS. 1 to 14C) may include a third flexible portion (e.g., 5314 in FIGS. 1 to 14C) spaced apart from the first flexible portion (e.g., 5313 in FIGS. 1 to 14C).

According to an embodiment of the disclosure, the first flexible circuit board (e.g., 531 in FIGS. 1 to 14C) may include a third rigid portion (e.g., 5312 in FIGS. 1 to 14C) connecting the second circuit board (e.g., 320 in FIGS. 1 to 14C) and the third flexible portion (e.g., 5314 in FIGS. 1 to 14C).

According to an embodiment of the disclosure, the second flexible circuit board (e.g., 532 in FIGS. 1 to 14C) may include a fourth flexible portion (e.g., 5324 in FIGS. 1 to 14C) spaced apart from the second flexible portion (e.g., 5323 in FIGS. 1 to 14C).

According to an embodiment of the disclosure, the second flexible circuit board (e.g., 532 in FIGS. 1 to 14C) may include a fourth rigid portion (e.g., 5322 in FIGS. 1 to 14C) connecting the second circuit board (e.g., 320 in FIGS. 1 to 14C) and the fourth flexible portion (e.g., 5324 in FIGS. 1 to 14C).

According to an embodiment of the disclosure, the first flexible circuit board (e.g., 531 in FIGS. 1 to 14C) may include a third boundary portion (e.g., 539 in FIGS. 1 to 14C) formed between the third flexible portion (e.g., 5314 in FIGS. 1 to 14C) and the third rigid portion (e.g., 5312 in FIGS. 1 to 14C).

According to an embodiment of the disclosure, the second flexible circuit board (e.g., 532 in FIGS. 1 to 14C) may include a fourth boundary portion (e.g., 539 in FIGS. 1 to 14C) formed between the fourth flexible portion (e.g., 5234 in FIGS. 1 to 14C) and the fourth rigid portion (e.g., 5322 in FIGS. 1 to 14C).

According to an embodiment of the disclosure, the third boundary portion (e.g., 539 in FIGS. 1 to 14C) and the fourth boundary portion (e.g., 539 in FIGS. 1 to 14C) are dislocated from each other.

According to an embodiment of the disclosure, the third boundary portion (e.g., 539 in FIGS. 1 to 14C) may be positioned closer to the second circuit board (e.g., 320 in FIGS. 1 to 14C than the fourth boundary portion (e.g., 539 in FIGS. 1 to 14C).

According to an embodiment of the disclosure, the third boundary portion (e.g., 539 in FIGS. 1 to 14C) may be positioned farther from the second circuit board (e.g., 320 in FIGS. 1 to 14C) than the fourth boundary portion (e.g., 539 in FIGS. 1 to 14C).

The electronic device (e.g., 101 in FIGS. 1 to 14C) according to an embodiment of the disclosure may include a body (e.g., 580 in FIGS. 1 to 14C) disposed to surround at least a portion of the first flexible circuit board (e.g., 531 in FIGS. 1 to 14C) and the second flexible circuit board (e.g., 532 in FIGS. 1 to 14C).

According to an embodiment of the disclosure, the body (e.g., 580 in FIGS. 1 to 14C) may be coupled to one of the first flexible circuit board (e.g., 531 in FIGS. 1 to 14C) or the second flexible circuit board (e.g., 532 in FIGS. 1 to 14C).

According to an embodiment of the disclosure, the body (e.g., 580 in FIGS. 1 to 14C) may include a first portion (e.g., 581 in FIGS. 1 to 14C) facing the first flexible circuit board (e.g., 531 in FIGS. 1 to 14C).

According to an embodiment of the disclosure, the body (e.g., 580 in FIGS. 1 to 14C) may include a second portion (e.g., 582 in FIGS. 1 to 14C) facing the second flexible circuit board (e.g., 532 in FIGS. 1 to 14C)

According to an embodiment of the disclosure, the body (e.g., 580 in FIGS. 1 to 14C) may include a bending portion (e.g., 583 in FIGS. 1 to 14C) connecting the first portion (e.g., 581 in FIGS. 1 to 14C) and the second portion (e.g., 582 in FIGS. 1 to 14C).

According to an embodiment of the disclosure, the body (e.g., 580 in FIGS. 1 to 14C) may include an opening (e.g., 584 in FIGS. 1 to 14C) formed between the first portion (e.g., 581 in FIGS. 1 to 14C) and the second portion (e.g., 582 in FIGS. 1 to 14C).

According to an embodiment of the disclosure, the body (e.g., 580 in FIGS. 1 to 14C) may include a second bending portion (e.g., 5840 in FIGS. 1 to 14C) connecting the first portion (e.g., 5810 in FIGS. 1 to 14C) and the second portion (e.g., 5820 in FIGS. 1 to 14C) and spaced apart from the first bending portion (e.g., 5830 in FIGS. 1 to 14C).

An electronic device (e.g., 101 in FIGS. 1 to 14C) according to an embodiment of the disclosure may include a first connector (e.g., 540 in FIGS. 1 to 14C) connecting the first and second flexible circuit boards (e.g., 531 and 532 in FIGS. 1 to 14C) to the first circuit board (e.g., 310 in FIGS. 1 to 14C).

The electronic device (e.g., 101 in FIGS. 1 to 14C) according to an embodiment of the disclosure may include a second connector (e.g., 550 in FIGS. 1 to 14C) connecting the first and second flexible circuit boards (e.g., 531 and 532 in FIGS. 1 to 14C) to the second circuit board (e.g., 320 in FIGS. 1 to 14C).

The electronic device (e.g., 101 in FIGS. 1 to 14C) according to an embodiment of the disclosure may include a flexible circuit board (e.g., 330, 530, or 630 in FIGS. 1 to 14C) electrically connecting the first circuit board (e.g., 310 in FIGS. 1 to 14C) and the second circuit board (e.g., 320 in FIGS. 1 to 14C).

According to an embodiment of the disclosure, the flexible circuit board (e.g., 330, 530, or 630 in FIGS. 1 to 14C) may include a first flexible portion (e.g., 335, 535, or 635 in FIGS. 1 to 14C) which is at least partially deformable.

According to an embodiment of the disclosure, the flexible circuit board (e.g., 330, 530, or 630 in FIGS. 1 to 14C) may include a first rigid portion (e.g., 333, 533, or 633 in FIGS. 1 to 14C) connecting the first flexible portion (e.g., 335, 535, or 635 in FIGS. 1 to 14C) to the first circuit board (e.g., 310 in FIGS. 1 to 14C).

According to an embodiment of the disclosure, the flexible circuit board (e.g., 330, 530, or 630 in FIGS. 1 to 14C) may include a second flexible portion (e.g., 336, 536, or 636 in FIGS. 1 to 14C), which is at least partially deformable and is spaced apart from the first flexible portion (e.g., 335, 535, or 635 in FIGS. 1 to 14C).

According to an embodiment of the disclosure, the flexible circuit board (e.g., 330, 530, or 630 in FIGS. 1 to 14C) may include a second rigid portion (e.g., 332, 532, or 632 in FIGS. 1 to 14C) connecting the second flexible portion (e.g., 336, 536, or 636 in FIGS. 1 to 14C) to the second circuit board (e.g., 320 in FIGS. 1 to 14C).

According to an embodiment of the disclosure, the flexible circuit board (e.g., 330, 530, or 630 in FIGS. 1 to 14C) may include a first layer (e.g., 531 in FIGS. 1 to 14C) including a (1-1)^{th} flexible portion (e.g., 5313 in FIGS. 1 to 14C) forming a portion of the first flexible portion (e.g., 535 in FIGS. 1 to 14C), a (1-1)^{th} rigid portion (e.g., 5311 in FIGS. 1 to 14C) forming a portion of the first rigid portion (e.g., 533 in FIGS. 1 to 14C), and a (1-1)^{th} boundary portion (e.g., 5381 in FIGS. 1 to 14C) formed between the (1-1)^{th} flexible portion (e.g., 5313 in FIGS. 1 to 14C) and the (1-1)^{th} rigid portion (e.g., 5311 in FIGS. 1 to 14C).

According to an embodiment of the disclosure, the flexible circuit board (e.g., 330, 530, or 630 in FIGS. 1 to 14C) may include a second layer (e.g., 532 in FIGS. 1 to 14C) including a (1-2)^{th} flexible portion (e.g., 5323 in FIGS. 1 to 14C) forming a portion of the first flexible portion (e.g., 535 in FIGS. 1 to 14C), a (1-2)^{th} rigid portion (e.g., 5321 in FIGS. 1 to 14C) forming a portion of the first rigid portion (e.g., 533 in FIGS. 1 to 14C), and a (1-2)^{th} boundary portion (e.g., 5382 in FIGS. 1 to 14C) formed between the (1-2)^{th} flexible portion (e.g., 5323 in FIGS. 1 to 14C) and the (1-2)^{th} rigid portion (e.g., 5321 in FIGS. 1 to 14C), wherein the second layer (e.g., 532 in FIGS. 1 to 14C) is distinct from the first layer (e.g., 531 in FIGS. 1 to 14C).

According to an embodiment of the disclosure, the (1-1)^{th} boundary portion (e.g., 5381 in FIGS. 1 to 14C) and the (1-2)^{th} boundary portion (e.g., 5382 in FIGS. 1 to 14C) may be dislocated from each other.

According to an embodiment of the disclosure, the (1-1)^{th} boundary portion (e.g., 5381 in FIGS. 1 to 14C) may be inclined with respect to a direction in which the flexible circuit board (e.g., 530 in FIGS. 1 to 14C) is extended, and the (1-2)^{th} boundary portion (e.g., 5382 in FIGS. 1 to 14C) is inclined with respect to a direction in which the flexible circuit board (e.g., 530 in FIGS. 1 to 14C) is extended.

The electronic device (e.g., 101 in FIGS. 1 to 14C) according to an embodiment of the disclosure may include a body (e.g., 580 in FIGS. 1 to 14C) disposed to surround at least a portion of the flexible circuit board (e.g., 530 in FIGS. 1 to 14C).

The electronic device (e.g., 101 in FIGS. 1 to 14C) according to an embodiment of the disclosure may include a first connector (e.g., 540 in FIGS. 1 to 14C) connecting the first circuit board (e.g., 310 in FIGS. 1 to 14C) to the flexible circuit board (e.g., 330 in FIGS. 1 to 14C).

The electronic device (e.g., 101 in FIGS. 1 to 14C) according to an embodiment of the disclosure may include a second connector (e.g., 550 in FIGS. 1 to 14C) connecting the second circuit board (e.g., 320 in FIGS. 1 to 14C) to the flexible circuit board (e.g., 330 in FIGS. 1 to 14C).

According to an embodiment of the disclosure, the body (e.g., 580 in FIGS. 1 to 14C) may be attached to one of the first layer (e.g., 531 in FIGS. 1 to 14C) and the second layer (e.g., 532 in FIGS. 1 to 14C) and disposed to surround at least a portion of the flexible printed circuit board (e.g., 530 in FIGS. 1 to 14C).

An electronic device (101 in FIGS. 1 to 14C) according to an embodiment of the disclosure may include: a first circuit board; a second circuit board electrically connected to the first circuit board; and a flexible circuit board including a first layer and a second layer and electrically connecting the first circuit board and the second circuit board via at least one of the first layer and the second layer, wherein at least a portion of the flexible circuit board may be configured to be deformable in response to a movement of at least one of the first circuit board and the second circuit board, wherein the first layer may include a 1-1 flexible portion, which is at least partially deformable, a 1-1 rigid portion connecting the 1-1 flexible portion to the first circuit board, and a 1-1 boundary portion formed between the 1-1 flexible portion and the 1-1 rigid portion, wherein the second layer may include a 1-2 flexible portion which is at least partially deformable, a 1-2 rigid portion connecting the 1-2 flexible portion to the first circuit board, and a 1-2 boundary portion formed between the 1-2 flexible portion and the 1-1 rigid portion, and wherein the 1-1 boundary portion and the 1-2 boundary portion may be dislocated from each other.

According to an embodiment of the disclosure, the 1-1 boundary portion may be inclined with respect to a direction in which the flexible circuit board is extended, and wherein the 1-2 boundary portion may be inclined with respect to a direction in which the flexible circuit board is extended.

The electronic device (e.g., 101 in FIGS. 1 to 14C) according to an embodiment of the disclosure may include a body disposed to surround at least a portion of the flexible circuit board.

According to an embodiment of the disclosure, the body may be disposed to surround at least a portion of the flexible printed circuit board by being attached to one of the first layer and the second layer.

The electronic device (e.g., 101 in FIGS. 1 to 14C) according to an embodiment of the disclosure may include a first connector connecting the first circuit board and the flexible circuit board; and a second connector connecting the second circuit board and the flexible circuit board.

Although specific embodiments have been described in the detailed description of the disclosure, it will be apparent to those skilled in the art that various modifications and changes may be made thereto without departing from the scope of the disclosure.

## Claims

1. An electronic device (101) comprising:
a first housing (201);
a second housing (202) configured to move with respect to the first housing between a slid-in state and a slid-out state;
a first circuit board (310) disposed inside the first housing (201);
a second circuit board (320) disposed inside the second housing (202);
a first flexible circuit board (331; 531; 631) electrically connecting the first circuit board (310) and the second circuit board (320), wherein at least a portion of the first flexible circuit board (331; 531; 631) is deformable according to a movement of the first housing (201) with respect to the second housing, wherein the first flexible circuit board (331; 531; 631) includes a first flexible portion (3313; 5313; 6313) and a first rigid portion (3311; 5311; 6311) formed between the first circuit board (310) and the first flexible portion (3313; 5313; 6313); and
a second flexible circuit board (332; 532; 632) electrically connecting the first circuit board (310) and the second circuit board (320), wherein at least a portion of the second flexible circuit board (332; 532; 632) is coupled to the first flexible circuit board (331; 531; 631) and is configured to be deformed according to a movement of the first housing (201) with respect to the second housing, wherein the second flexible circuit board (332; 532; 632) includes a second flexible portion (3323; 5323; 6323) and a second rigid portion (3321; 5321; 6321) formed between the first circuit board (310) and the second flexible portion (3323; 5323; 6323),
wherein a first boundary portion (5381; 6381) formed between the first flexible portion (3313; 5313; 6313) and the first rigid portion (3311; 5311; 6311) is not aligned with a second boundary portion (5382; 6382) formed between the second flexible portion (3323; 5323; 6323) and the second rigid portion (3321; 5321; 6321),
wherein the first flexible circuit board (431; 531; 631) includes a third flexible portion (4314; 5314; 6314) spaced apart from the first flexible portion (4313; 5313; 6313),
wherein the second flexible circuit board (432; 532; 632) includes a fourth flexible portion (5324) spaced apart from the second flexible portion (4323; 5323; 6323), and
wherein the first flexible portion, the second flexible portion, the third flexible portion and the fourth flexible portion are bent in the slide-in state.

2. The electronic device (101) of claim 1,
wherein the first boundary portion (5381) and the second boundary portion (5382) are dislocated from each other in a direction intersecting with an extended direction of the first flexible circuit board (531) and the second flexible circuit board (532).

3. The electronic device of any one of claim 1 or 2,
wherein the first rigid portion (5311) includes:
a plurality of first layers (5316) stacked with each other; and
a first adhesive member (5317) disposed between the plurality of first layers (5316) and extending to the first boundary portion (5381),
wherein the second rigid portion (5321) includes:
a plurality of second layers (5326) stacked with each other; and
a second adhesive member (5327) disposed between the plurality of second layers (5326) and extending to the second boundary portion (5382).

4. The electronic device of any one of claims 1 to 3,
wherein the first boundary portion (5381) is inclined with respect to a direction in which the first flexible circuit board (531) is extended, and
wherein the second boundary portion (5382) is inclined with respect to a direction in which the second flexible circuit board (532) is extended.

5. The electronic device of any one of claims 1 to 4,
wherein the first boundary portion (5381) is positioned closer to the first circuit board (310) than the second boundary portion (5382).

6. The electronic device of any one of claims 1 to 5,
wherein the first boundary portion (6381) is positioned farther from the first circuit board (310) than the second boundary portion (5382).

7. The electronic device of any one of claims 1 to 6,
wherein the first flexible circuit board (531) further includes a third rigid portion (5312) connecting the second circuit board (320) and the third flexible portion (5314),
wherein the second flexible circuit board (532) includes a fourth rigid portion (5322) connecting the second circuit board (320) and the fourth flexible portion (5324).

8. The electronic device of claim 7,
wherein the first flexible circuit board (531) includes a third boundary portion (539) formed between the third flexible portion (5314) and the third rigid portion (5312),
wherein the second flexible circuit board (532) includes a fourth boundary portion (539) formed between the fourth flexible portion (5234) and the fourth rigid portion (5322),
wherein the third boundary portion (539) and the fourth boundary portion (539) are dislocated from each other.

9. The electronic device of claim 8,
wherein the third boundary portion (539) is positioned closer to the second circuit board (320) than the fourth boundary portion (539).

10. The electronic device of any one of claim 8 or 9,
wherein the third boundary portion (539) is positioned farther from the second circuit board (320) than the fourth boundary portion (539).

11. The electronic device of any one of claims 1 to 10, further comprising:
a body (580) disposed to surround at least a portion of the first flexible circuit board (531) and the second flexible circuit board (532).

12. The electronic device of claim 11,
wherein the body (580) is coupled to one of the first flexible circuit board (531) or the second flexible circuit board (532).

13. The electronic device of any one of claim 11 or 12,
wherein the body (580) comprises:
a first portion (581) facing the first flexible circuit board (531);
a second portion (582) facing the second flexible circuit board (532);
a bending portion (583) connecting the first portion (581) and the second portion (582); and
an opening (584) formed between the first portion (581) and the second portion (582).

14. The electronic device of any one of claims 11 to 13,
wherein the body (5800) comprises:
a first portion (5810) facing the first flexible circuit board (531);
a second portion (5820) facing the second flexible circuit board (532);
a first bending portion (5830) connecting the first portion(5810) and the second portion (5820); and
a second bending portion (5840) connecting the first portion (5810) and the second portion (5820) and spaced apart from the first bending portion (5830).

15. The electronic device of any one of claims 1 to 14, further comprising:
a first connector (540) connecting the first and second circuit boards (531, 532) to the first circuit board (310); and
a second connector (550) connecting the first and second circuit boards (531, 532) to the second circuit board (320).

## Patentansprüche

1. Elektronische Vorrichtung (101), umfassend:
ein erstes Gehäuse (201);
ein zweites Gehäuse (202), das konfiguriert ist, um sich in Bezug auf das erste Gehäuse zwischen einem eingeschobenen Zustand und einem herausgeschobenen Zustand zu bewegen;
eine erste Platine (310), die in dem ersten Gehäuse (201) angeordnet ist;
eine zweite Platine (320), die in dem zweiten Gehäuse (202) angeordnet ist;
eine erste flexible Platine (331; 531; 631), die die erste Platine (310) und die zweite Platine (320) elektrisch verbindet, wobei mindestens ein Abschnitt der ersten flexiblen Platine (331; 531; 631) entsprechend einer Bewegung des ersten Gehäuses (201) in Bezug auf das zweite Gehäuse verformbar ist, wobei die erste flexible Platine (331; 531; 631) einen ersten flexiblen Abschnitt (3313; 5313; 6313) und einen ersten starren Abschnitt (3311; 5311; 6311) beinhaltet, der zwischen der ersten Platine (310) und dem ersten flexiblen Abschnitt (3313; 5313; 6313) ausgebildet ist; und
eine zweite flexible Platine (332; 532; 632), die die erste Platine (310) und die zweite Platine (320) elektrisch verbindet, wobei mindestens ein Abschnitt der zweiten flexiblen Platine (332; 532; 632) mit der ersten flexiblen Platine (331; 531; 631) gekoppelt ist und konfiguriert ist, um sich entsprechend einer Bewegung des ersten Gehäuses (201) in Bezug auf das zweite Gehäuse zu verformen, wobei die zweite flexible Platine (332; 532; 632) einen zweiten flexiblen Abschnitt (3323; 5323; 6323) und einen zweiten starren Abschnitt (3321; 5321; 6321) beinhaltet, der zwischen der ersten Platine (310) und dem zweiten flexiblen Abschnitt (3323; 5323; 6323) ausgebildet ist,
wobei ein erster Grenzabschnitt (5381; 6381), der zwischen dem ersten flexiblen Abschnitt (3313; 5313; 6313) und dem ersten starren Abschnitt (3311; 5311; 6311) ausgebildet ist, nicht mit einem zweiten Grenzabschnitt (5382; 6382) fluchtet, der zwischen dem zweiten flexiblen Abschnitt (3323; 5323; 6323) und dem zweiten starren Abschnitt (3321; 5321; 6321) gebildet ist,
wobei die erste flexible Platine (431; 531; 631) einen dritten flexiblen Abschnitt (4314; 5314; 6314) beinhaltet, der von dem ersten flexiblen Abschnitt (4313; 5313; 6313) beabstandet ist,
wobei die zweite flexible Platine (432; 532; 632) einen vierten flexiblen Abschnitt (5324) beinhaltet, der von dem zweiten flexiblen Abschnitt (4323; 5323; 6323) beabstandet ist, und
wobei der erste flexible Abschnitt, der zweite flexible Abschnitt, der dritte flexible Abschnitt und der vierte flexible Abschnitt im eingeschobenen Zustand gebogen sind.

2. Elektronische Vorrichtung (101) nach Anspruch 1,
wobei der erste Grenzabschnitt (5381) und der zweite Grenzabschnitt (5382) in einer Richtung, die die Erstreckungsrichtung der ersten flexiblen Platine (531) und der zweiten flexiblen Platine (532) schneidet, zueinander versetzt sind.

3. Elektronische Vorrichtung nach einem der Ansprüche 1 oder 2,
wobei der erste starre Abschnitt (5311) Folgendes beinhaltet:
eine Vielzahl von ersten Schichten (5316), die miteinander gestapelt sind; und
ein erstes Klebeelement (5317), das zwischen der Vielzahl von ersten Schichten (5316) angeordnet ist und sich zu dem ersten Grenzabschnitt (5381) erstreckt,
wobei der zweite starre Abschnitt (5321) Folgendes beinhaltet:
eine Vielzahl von zweiten Schichten (5326), die miteinander gestapelt sind; und
ein zweites Klebeelement (5327), das zwischen der Vielzahl von zweiten Schichten (5326) angeordnet ist und sich zu dem zweiten Grenzabschnitt (5382) erstreckt.

4. Elektronische Vorrichtung nach einem der Ansprüche 1 bis 3,
wobei der erste Grenzabschnitt (5381) in Bezug auf eine Richtung, in der sich die erste flexible Platine (531) erstreckt, geneigt ist, und
wobei der zweite Grenzabschnitt (5382) in Bezug auf eine Richtung, in der sich die zweite flexible Platine (532) erstreckt, geneigt ist.

5. Elektronische Vorrichtung nach einem der Ansprüche 1 bis 4,
wobei der erste Grenzabschnitt (5381) näher an der ersten Platine (310) positioniert ist als der zweite Grenzabschnitt (5382).

6. Elektronische Vorrichtung nach einem der Ansprüche 1 bis 5,
wobei der erste Grenzabschnitt (6381) weiter von der ersten Platine (310) weg positioniert ist als der zweite Grenzabschnitt (5382).

7. Elektronische Vorrichtung nach einem der Ansprüche 1 bis 6,
wobei die erste flexible Platine (531) ferner einen dritten starren Abschnitt (5312) beinhaltet, der die zweite Platine (320) und den dritten flexiblen Abschnitt (5314) verbindet,
wobei die zweite flexible Platine (532) einen vierten starren Abschnitt (5322) beinhaltet, der die zweite Platine (320) und den vierten flexiblen Abschnitt (5324) verbindet.

8. Elektronische Vorrichtung nach Anspruch 7,
wobei die erste flexible Platine (531) einen dritten Grenzabschnitt (539) beinhaltet, der zwischen dem dritten flexiblen Abschnitt (5314) und dem dritten starren Abschnitt (5312) ausgebildet ist,
wobei die zweite flexible Platine (532) einen vierten Grenzabschnitt (539) beinhaltet, der zwischen dem vierten flexiblen Abschnitt (5234) und dem vierten starren Abschnitt (5322) ausgebildet ist,
wobei der dritte Grenzabschnitt (539) und der vierte Grenzabschnitt (539) zueinander versetzt sind.

9. Elektronische Vorrichtung nach Anspruch 8,
wobei der dritte Grenzabschnitt (539) näher an der zweiten Platine (320) positioniert ist als der vierte Grenzabschnitt (539).

10. Elektronische Vorrichtung nach einem der Ansprüche 8 oder 9,
wobei der dritte Grenzabschnitt (539) weiter von der zweiten Platine (320) weg positioniert ist als der vierte Grenzabschnitt (539).

11. Elektronische Vorrichtung nach einem der Ansprüche 1 bis 10, ferner umfassend:
einen Körper (580), der so angeordnet ist, dass er mindestens einen Abschnitt der ersten flexiblen Platine (531) und der zweiten flexiblen Platine (532) umschließt.

12. Elektronische Vorrichtung nach Anspruch 11,
wobei der Körper (580) entweder mit einer der ersten flexiblen Platine (531) oder der zweiten flexiblen Platine (532) gekoppelt ist.

13. Elektronische Vorrichtung nach einem der Ansprüche 11 oder 12,
wobei der Körper (580) Folgendes umfasst:
einen ersten Abschnitt (581), der der ersten flexiblen Platine (531) zugewandt ist;
einen zweiten Abschnitt (582), der der zweiten flexiblen Platine (532) zugewandt ist;
einen Biegeabschnitt (583), der den ersten Abschnitt (581) und den zweiten Abschnitt (582) verbindet; und
eine Öffnung (584), die zwischen dem ersten Abschnitt (581) und dem zweiten Abschnitt (582) ausgebildet ist.

14. Elektronische Vorrichtung nach einem der Ansprüche 11 bis 13,
wobei der Körper (5800) Folgendes umfasst:
einen ersten Abschnitt (5810), der der ersten flexiblen Platine (531) zugewandt ist;
einen zweiten Abschnitt (5820), der der zweiten flexiblen Platine (532) zugewandt ist;
einen ersten Biegeabschnitt (5830), der den ersten Abschnitt (5810) und den zweiten Abschnitt (5820) verbindet; und
einen zweiten Biegeabschnitt (5840), der den ersten Abschnitt (5810) und den zweiten Abschnitt (5820) verbindet und von dem ersten Biegeabschnitt (5830) beabstandet ist.

15. Elektronische Vorrichtung nach einem der Ansprüche 1 bis 14, ferner umfassend:
ein erstes Verbindungsstück (540), das die erste und die zweite Platine (531, 532) mit der ersten Platine (310) verbindet; und
ein zweites Verbindungsstück (550), das die erste und die zweite Platine (531, 532) mit der zweiten Platine (320) verbindet.

## Revendications

1. Dispositif électronique (101) comprenant :
un premier boîtier (201) ;
un second boîtier (202) configuré pour se déplacer par rapport au premier boîtier entre un état de coulissement vers l'extérieur et un état de coulissement vers l'intérieur ;
une première carte de circuit imprimé (310) disposée dans le premier boîtier (201) ;
une deuxième carte de circuit imprimé (320) disposée dans le deuxième boîtier (202) ;
une première carte de circuit imprimé flexible (331 ; 531 ; 631) reliant électriquement la première carte de circuit imprimé (310) et la deuxième carte de circuit imprimé (320), au moins une partie de la première carte de circuit imprimé flexible (331 ; 531 ; 631) étant déformable en fonction d'un mouvement du premier boîtier (201) par rapport au second boîtier, la première carte de circuit imprimé flexible (331 ; 531 ; 631) comprenant une première partie flexible (3313 ; 5313 ; 6313) et une première partie rigide (3311 ; 5311 ; 6311) formée entre la première carte de circuit imprimé (310) et la première partie flexible (3313 ; 5313 ; 6313) ; et
une deuxième carte de circuit imprimé flexible (332 ; 532 ; 632) reliant électriquement la première carte de circuit imprimé (310) et la deuxième carte de circuit imprimé (320), au moins une partie de la deuxième carte de circuit imprimé flexible (332 ; 532 ; 632) étant couplée à la première carte de circuit imprimé flexible (331 ; 531 ; 631) et étant configurée pour être déformée en fonction d'un mouvement du premier boîtier (201) par rapport au second boîtier, la deuxième carte de circuit imprimé flexible (332 ; 532 ; 632) comprenant une deuxième partie flexible (3323 ; 5323 ; 6323) et une deuxième partie rigide (3321 ; 5321 ; 6321) formée entre la première carte de circuit imprimé (310) et la deuxième partie flexible (3323 ; 5323 ; 6323),
dans lequel une première partie de limite (5381 ; 6381) formée entre la première partie flexible (3313 ; 5313 ; 6313) et la première partie rigide (3311 ; 5311 ; 6311) n'est pas alignée avec une deuxième partie de limite (5382 ; 6382) formée entre la deuxième partie flexible (3323 ; 5323 ; 6323) et la deuxième partie rigide (3321 ; 5321 ; 6321),
dans lequel la première carte de circuit imprimé flexible (431 ; 531 ; 631) comprend une troisième partie flexible (4314 ; 5314 ; 6314) espacée de la première partie flexible (4313 ; 5313 ; 6313),
dans lequel la deuxième carte de circuit imprimé flexible (432 ; 532 ; 632) comprend une quatrième partie flexible (5324) espacée de la deuxième partie flexible (4323 ; 5323 ; 6323), et
dans lequel la première partie flexible, la deuxième partie flexible, la troisième partie flexible et la quatrième partie flexible sont pliées à l'état de coulissement vers l'intérieur.

2. Dispositif électronique (101) de la revendication 1,
dans lequel la première partie de limite (5381) et la deuxième partie de limite (5382) sont décalées l'une par rapport à l'autre dans une direction coupant la direction d'extension de la première carte de circuit imprimé flexible (531) et de la deuxième carte de circuit imprimé flexible (532).

3. Dispositif électronique de l'une quelconque des revendications 1 ou 2,
dans lequel la première partie rigide (5311) comprend :
une pluralité de premières couches (5316) empilées les unes sur les autres ; et
un premier élément adhésif (5317) disposé entre la pluralité de premières couches (5316) et s'étendant à la première partie de limite (5381),
dans lequel la deuxième partie rigide (5321) comprend :
une pluralité de deuxièmes couches (5326) empilées les unes sur les autres ; et
un deuxième élément adhésif (5327) disposé entre la pluralité de deuxièmes couches (5326) et s'étendant à la deuxième partie de limite (5382).

4. Dispositif électronique de l'une quelconque des revendications 1 à 3,
dans lequel la première partie de limite (5381) est inclinée par rapport à une direction dans laquelle s'étend la première carte de circuit imprimé flexible (531), et
dans lequel la deuxième partie de limite (5382) est inclinée par rapport à une direction dans laquelle s'étend la deuxième carte de circuit imprimé flexible (532).

5. Dispositif électronique de l'une quelconque des revendications 1 à 4,
dans lequel la première partie de limite (5381) est positionnée plus près de la première carte de circuit imprimé (310) que la deuxième partie de limite (5382).

6. Dispositif électronique de l'une quelconque des revendications 1 à 5,
dans lequel la première partie de limite (6381) est positionnée plus loin de la première carte de circuit imprimé (310) que la deuxième partie de limite (5382).

7. Dispositif électronique de l'une quelconque des revendications 1 à 6,
dans lequel la première carte de circuit imprimé flexible (531) comprend en outre une troisième partie rigide (5312) reliant la deuxième carte de circuit imprimé (320) et la troisième partie flexible (5314),
dans lequel la deuxième carte de circuit imprimé flexible (532) comprend une quatrième partie rigide (5322) reliant la deuxième carte de circuit imprimé (320) et la quatrième partie flexible (5324).

8. Dispositif électronique de la revendication 7,
dans lequel la première carte de circuit imprimé flexible (531) comprend une troisième partie de limite (539) formée entre la troisième partie flexible (5314) et la troisième partie rigide (5312),
dans lequel la deuxième carte de circuit imprimé flexible (532) comprend une quatrième partie de limite (539) formée entre la quatrième partie flexible (5234) et la quatrième partie rigide (5322),
dans lequel la troisième partie de limite (539) et la quatrième partie de limite (539) sont décalées l'une par rapport à l'autre.

9. Dispositif électronique de la revendication 8,
dans lequel la troisième partie de limite (539) est positionnée plus près de la deuxième carte de circuit imprimé (320) que la quatrième partie de limite (539).

10. Dispositif électronique de l'une quelconque des revendications 8 ou 9,
dans lequel la troisième partie de limite (539) est positionnée plus loin de la deuxième carte de circuit imprimé (320) que la quatrième partie de limite (539).

11. Dispositif électronique de l'une des revendications 1 à 10, comprenant en outre :
un corps (580) disposé de manière à entourer au moins une partie de la première carte de circuit imprimé flexible (531) et de la deuxième carte de circuit imprimé flexible (532).

12. Dispositif électronique de la revendication 11,
dans lequel le corps (580) est couplé à l'une de la première carte de circuit imprimé flexible (531) ou de la deuxième carte de circuit imprimé flexible (532).

13. Dispositif électronique de l'une quelconque des revendications 11 ou 12,
dans lequel le corps (580) comprend :
une première partie (581) faisant face à la première carte de circuit imprimé flexible (531) ;
une deuxième partie (582) faisant face à la deuxième carte de circuit imprimé flexible (532) ;
une partie de courbure (583) reliant la première partie (581) et la deuxième partie (582) ; et
une ouverture (584) formée entre la première partie (581) et la deuxième partie (582).

14. Dispositif électronique de l'une quelconque des revendications 11 à 13,
dans lequel le corps (5800) comprend :
une première partie (5810) faisant face à la première carte de circuit imprimé flexible (531) ;
une deuxième partie (5820) faisant face à la deuxième carte de circuit imprimé flexible (532) ;
une première partie de courbure (5830) reliant la première partie (5810) et la deuxième partie (5820) ; et
une deuxième partie de courbure (5840) reliant la première partie (5810) et la deuxième partie (5820) et étant espacée de la première partie de courbure (5830).

15. Dispositif électronique de l'une des revendications 1 à 14, comprenant en outre :
un premier connecteur (540) reliant les première et deuxième cartes de circuit imprimé (531, 532) à la première carte de circuit imprimé (310) ; et
un second connecteur (550) reliant les première et deuxième cartes de circuit imprimé (531, 532) à la deuxième carte de circuit imprimé (320).
